# EUROPEAN PATENT APPLICATION

(11) **EP 4 641 833 A1**
(43) Date of publication of application: **29.10.2025**
(21) Application number: 24747448.9
(22) Date of filing: 24.01.2024
(51) Int. Cl.: H01Q 1/38, H01Q 1/24, H04M 1/02

(54) **ELECTRONIC DEVICE COMPRISING ANTENNA**

(30) Priority: 25.01.2023 KR 20230009744; 31.01.2023 KR 20230013087
(71) Applicant: Samsung Electronics Co., Ltd., Suwon-si, Gyeonggi-do 16677 (KR)
(72) Inventor: LEE, Minkyung, Suwon-si Gyeonggi-do 16677 (KR); JEONG, Uichul, Suwon-si Gyeonggi-do 16677 (KR); KIM, Kyunggu, Suwon-si Gyeonggi-do 16677 (KR); BAE, Hongpyo, Suwon-si Gyeonggi-do 16677 (KR); PARK, Gyubok, Suwon-si Gyeonggi-do 16677 (KR)
(74) Representative: HGF
(86) International application number: PCT/KR2024/001151
(87) International publication number: WO 2024/158213

(57) **Abstract**

An electronic device according to an embodiment comprises: a processor; a memory in which instructions are stored; a housing; a conductive part; a printed circuit board for providing a first ground; an electronic component for providing a second ground; a switch circuit; and a wireless communication circuit. The instructions may, when executed by the processor, cause the electronic device to control the switch circuit to electrically connect the conductive part and the printed circuit board to each other, or control the switch circuit to electrically connect the conductive part and the electronic component to each other.

## Description

### [Technical Field]

The present disclosure relates to an electronic device including an antenna.

### [Background Art]

An electronic device may transmit or receive a signal through an antenna. The electronic device may include a conductive portion formed at a portion of a periphery of a housing. The conductive portion may operate as an antenna radiator for transmitting and/or receiving a signal by being fed from wireless communication circuitry. The electronic device may provide a ground for an antenna including a conductive portion. A ground for providing higher radiation efficiency may be different in accordance with a frequency band of a signal to be transmitted and/or received.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

According to an embodiment, an electronic device may comprise a processor, memory storing instructions, a housing, a conductive portion, a printed circuit board (PCB), an electronic component, a switch circuit, and wireless communication circuitry. The housing may include a support. The conductive portion may be positioned along at least a portion of a periphery of the housing. The PCB may be electrically connected to the support. The PCB may be configured to provide a first ground. The PCB may be disposed in the housing. The electronic component may be electrically connected to a ground layer of the PCB through a connecting member. The electronic component may be configured to provide a second ground different from the first ground. The switch circuit may be configured to electrically connect the conductive portion to the ground layer of the PCB or the electronic component. The wireless communication circuitry may be configured to communicate with an external electronic device through the conductive portion. The instructions, when executed by the processor, may cause the electronic device to control the switch circuit, when the wireless communication circuitry transmits or receives a signal on a first frequency band, to electrically connect the conductive portion to the PCB. The instructions may cause to the electronic device to control the switch circuit, when the wireless communication circuitry transmits or receives a signal on a second frequency band higher than the first frequency band, to electrically connect the conductive portion to the electronic component.

According to an embodiment, an electronic device may include a processor, memory storing instructions, a housing, a conductive portion, a printed circuit board (PCB), an electronic component, a switch circuit, wireless communication circuitry, and a conductive member. The housing may include a support. The conductive portion may be positioned along at least a portion of a periphery of the housing. The printed circuit board may be electrically connected to the support and a ground portion of the conductive portion. The printed circuit board may be configured to provide a first ground. The printed circuit board may be disposed in the housing. The electronic component may be electrically connected to a ground layer of the printed circuit board through a connecting member. The electronic component may be configured to provide a second ground different from the first ground. The switch circuit may be configured to electrically connect the conductive portion to a ground layer of the printed circuit board or the electronic component. The wireless communication circuitry may be configured to communicate with an external electronic device through the conductive portion. The conductive member may at least partially overlap the electronic component. The conductive member may change a coupling position between the conductive portion and the electronic component within the conductive portion, by being coupled with the electronic component. The wireless communication circuitry may be configured to communicate with the external electronic device based on a resonant frequency according to the changed coupling position, in a state that the conductive portion and the electronic component are electrically connected through the switch circuit.

### [Description of the Drawings]

FIG. 1 is a block diagram of an electronic device in a network environment according to various embodiments.
FIG. 2A is a front view of an exemplary electronic device.
FIG. 2B schematically illustrates a cross-section of an exemplary electronic device cut along A-A' of FIG. 2A.
FIG. 3 is a simplified block diagram of an exemplary electronic device.
FIG. 4A schematically illustrates a state in which an electronic device transmits or receives a signal on a first frequency band.
FIG. 4B schematically illustrates a state in which an electronic device transmits or receives a signal on a second frequency band.
FIG. 5 is a graph indicating a radiation characteristic of an antenna according to a frequency band and a ground.
FIG. 6A schematically illustrates a state in which an electronic device transmits or receives a signal on a first frequency band.
FIG. 6B schematically illustrates a state in which an electronic device transmits or receives a signal on a second frequency band.
FIGS. 7A and 7B schematically illustrate a state in which an electronic device provides a ground by using a plurality of electronic components.
FIG. 8 schematically illustrates an exemplary electronic device including a conductive member for changing a coupling position between a conductive portion and an electronic component.
FIG. 9A illustrates a position of a feeding portion and a coupling point within a conductive portion of an exemplary electronic device.
FIG. 9B is a graph indicating a radiation characteristic of an antenna including at least a portion of a conductive portion of FIG. 9A.
FIGS. 10A and 10B schematically illustrate a cross section of an exemplary electronic device cut along B-B' of FIG. 8.
FIG. 11A illustrates a conductive member positioned in various positions.
FIG. 11B is a graph indicating a radiation characteristic change of an antenna including at least a portion of a conductive portion according to a position of a conductive member.
FIG. 11C is a graph indicating a reflection coefficient of an antenna including at least a portion of a conductive portion according to a position of a conductive member.

### [Mode for Invention]

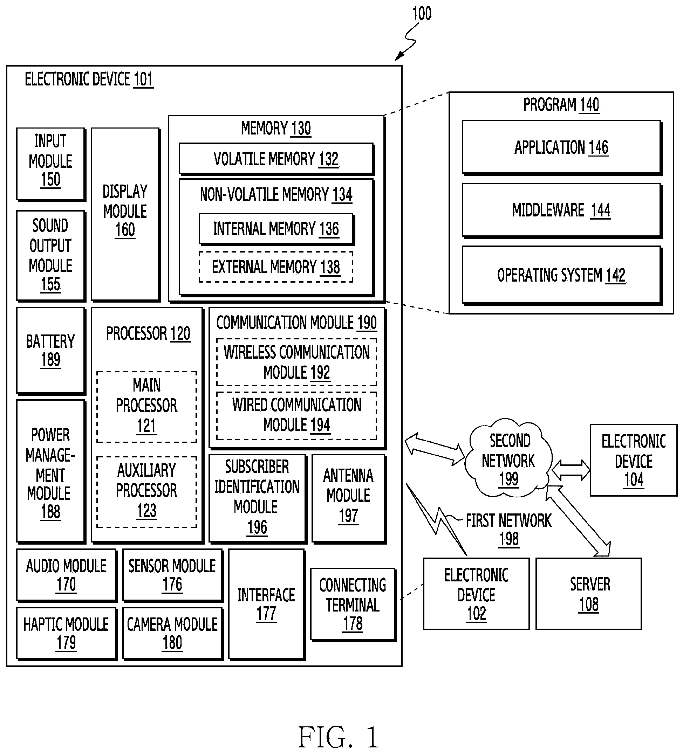

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

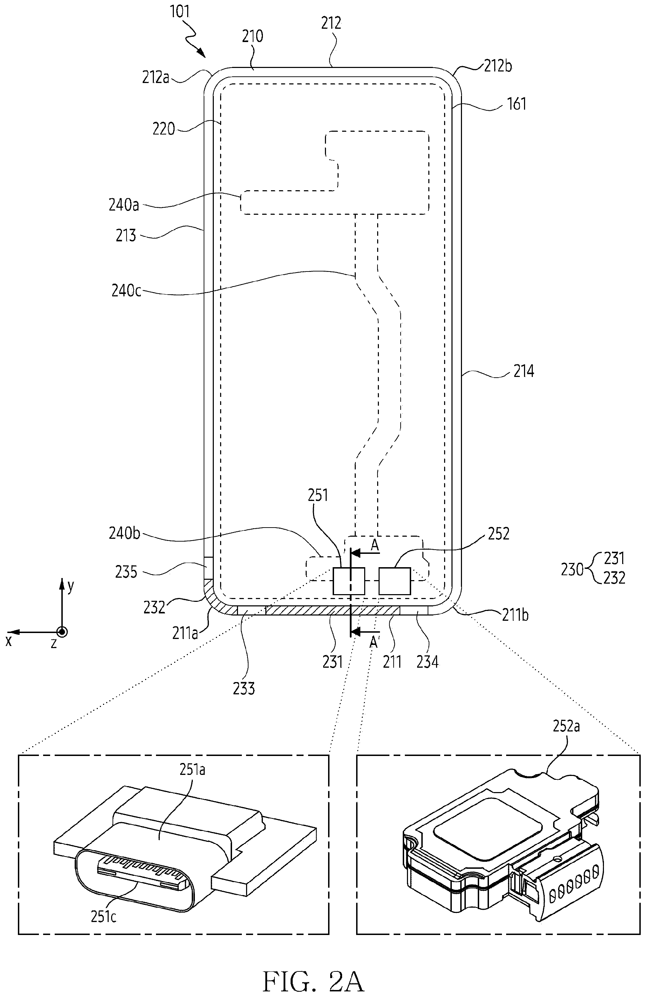

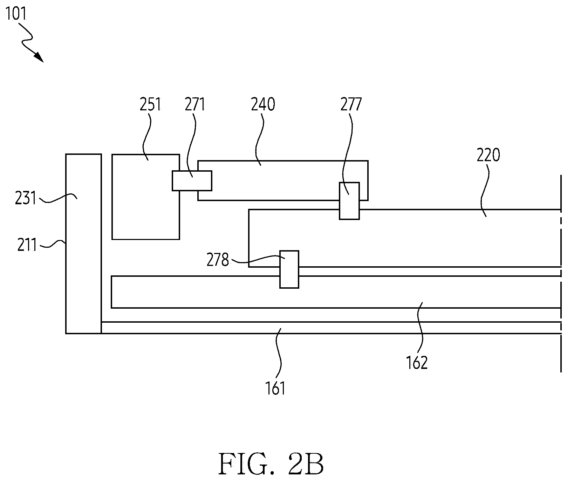

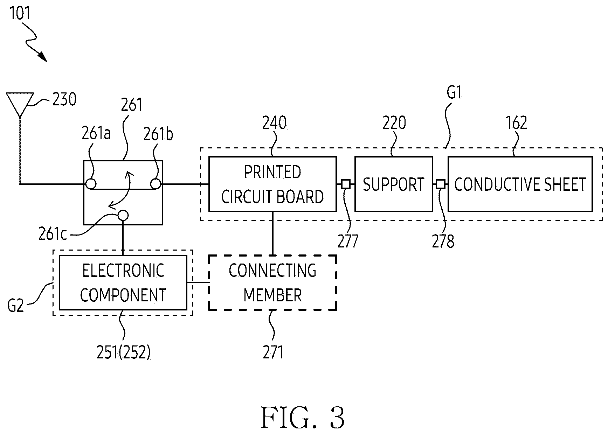

FIG. 2A is a front view of an exemplary electronic device. FIG. 2B schematically illustrates a cross-section of an exemplary electronic device cut along A-A' of FIG. 2A. FIG. 3 is a simplified block diagram of an exemplary electronic device.

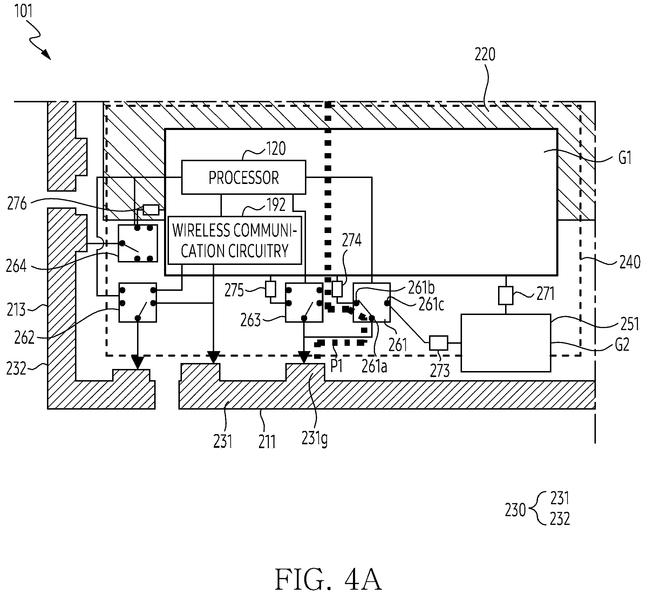

Referring to FIGS. 2A, 2B, and 3, an electronic device 101 according to an embodiment may include a processor (e.g., the processor 120 of FIG. 4A), a housing 210, a conductive portion 230, a printed circuit board 240, electronic components 251 and 252, a switch circuit (e.g., the switch circuit 261 of FIG. 3), and wireless communication circuitry (e.g., the wireless communication circuitry 192 of FIG. 4A).

Referring to FIG. 2A, the housing 210 may form an exterior of the electronic device 101. For example, components for various functions of the electronic device 101 may be disposed inside and/or outside the housing 210. For example, a display 161 may be disposed over the housing 210 (e.g., +z direction). For example, the processor 120, the printed circuit board 240, and/or the wireless communication circuitry 192 may be disposed within the housing 210.

According to an embodiment, the housing 210 may include a first periphery 211, a second periphery 212, a third periphery 213, and a fourth periphery 214 that form an exterior of the electronic device 101. For example, the first periphery 211 and the second periphery 212 may be opposite to each other. The third periphery 213 and the fourth periphery 214 may be opposite to each other. For example, the third periphery 213 and the fourth periphery 214 may be perpendicular to the first periphery 211 and the second periphery 212. For example, the third periphery 213 may extend from a first end 211a of the first periphery 211 to a second end 212a of the second periphery 212. For example, the fourth periphery 214 may extend from a third end 211b opposite the first end 211a to a fourth end 212b opposite the second end 212a. For example, the first periphery 211 may be a periphery of the housing 210 in the -y direction. The second periphery 212 may be a periphery of the housing 210 in the +y direction. For example, the third periphery 213 may be a periphery of the housing 210 in the +x direction. The fourth periphery 214 may be a periphery of the housing 210 in the -x direction. However, it is not limited thereto.

According to an embodiment, the housing 210 may include a support 220. The support 220 may be configured to support components disposed within the housing 210. For example, support 220 may extend from a side member forming a plurality of peripheries toward the inside of the housing 210. At least a portion of the support 220 may be configured to provide a ground for components in the electronic device 101. For example, the support 220 may include a conductive material (e.g., metal). The electronic device 101 according to an embodiment may include a conductive sheet (e.g., the conductive sheet 162 of FIG. 2B) for shorting the display 161 and the support 220. The conductive sheet 162 may be positioned between the display 161 and the support 220. For example, referring to FIG. 2B, the conductive sheet 162 may be electrically connected to the support 220 through a connecting member 278.

According to an embodiment, the conductive portion 230 may be positioned along at least a portion of a periphery of the housing 210. For example, the conductive portion 230 may include a first conductive portion 231 or a second conductive portion 232. According to an embodiment, the first conductive portion 231 may be positioned along a portion of the first periphery 211 of the housing 210. The first conductive portion 231 may extend from a first non-conductive portion 233 within the first periphery 211 to a second non-conductive portion 234 within the first periphery 211. For example, the first non-conductive portion 233 may be closer to the first end 211a among the first end 211a and the second end 211b. The second non-conductive portion 234 may be closer to the second end 211b among the first end 211a and the second end 211b. According to an embodiment, the second conductive portion 232 may extend from the first non-conductive portion 233 to a third non-conductive portion 235 within the third periphery 213 through the first end 211a. For example, a portion of the second conductive portion 232 may be positioned at the first periphery 211. A remaining portion of the second conductive portion 232 may be positioned at the third periphery 213. In addition, the conductive portion 230 may be variously positioned along a periphery of the housing 210.

According to an embodiment, the printed circuit board 240 may be configured to provide an electrical connection between components within the housing 210. For example, the printed circuit board (PCB) 240 may include a plurality of conductive layers and a plurality of non-conductive layers alternately laminated with the conductive layers. The PCB 240 may provide an electrical connection between various components disposed outside the printed circuit board 240 and/or the printed circuit board 240 using wirings and conductive vias formed on the conductive layer.

According to an embodiment, the electronic device 101 may include a plurality of PCBs 240a and 240b. For example, the electronic device 101 may include a first PCB 240a and a second PCB 240b spaced apart from each other within the housing 210. The first PCB 240a and the second PCB 240b may be electrically connected through a connecting member 240c. For example, the connecting member 240c may be a coaxial cable, a flexible RF cable (FRC), or a flexible printed circuit board (FPCB) for transmitting and/or receiving a signal, but is not limited thereto.

According to an embodiment, the PCB 240 may include a ground layer that provides a ground to components. For example, a ground portion of the components may be electrically connected to a ground layer of the PCB 240, and the ground layer may be electrically connected to the support 220. For example, referring to FIG. 2B, the ground layer of the PCB 240 may be electrically connected to the support 220 through a connecting member 277. The components of the electronic device 101 may be electrically connected to the support 220 through the ground layer of the PCB 240.

Referring to FIG. 2B, the ground layer of the PCB 240 may be configured to provide a ground by being electrically connected to the support 220. For example, the conductive sheet 162 disposed between the display 161 and the support 220 may be electrically connected to the support 220. The ground layer of the PCB 240 may be electrically connected to the support 220. A ground formed by the ground layer of the PCB 240, the support 220, and/or the conductive sheet 162 electrically connected to each other may be referred to as a first ground (e.g., the first ground G1 of FIG. 3).

According to an embodiment, electronic components 251 and 252 may be disposed within the housing 210 to implement various functions of the electronic device 101. For example, the electronic components 251 and 252 may include a connection terminal connected to an external electronic device (e.g., the electronic device 102 of FIG. 1), a speaker, and/or a microphone, but is not limited thereto. According to an embodiment, the electronic components 251 and 252 may be electrically connected to the ground layer of the PCB 240.

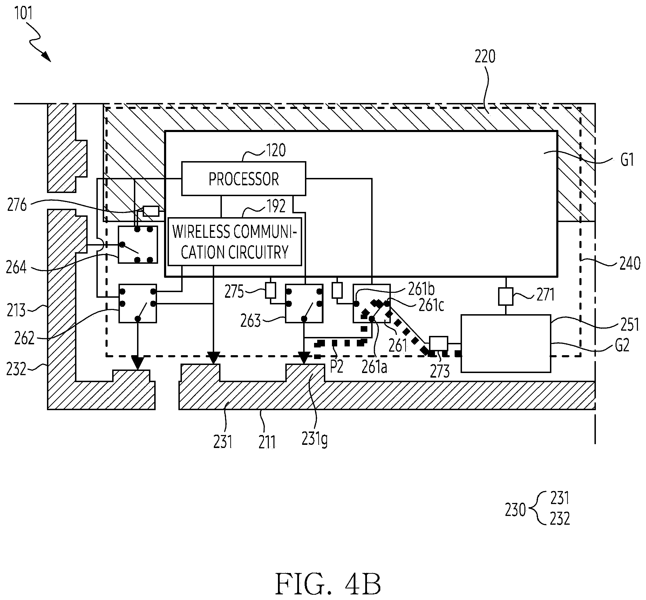

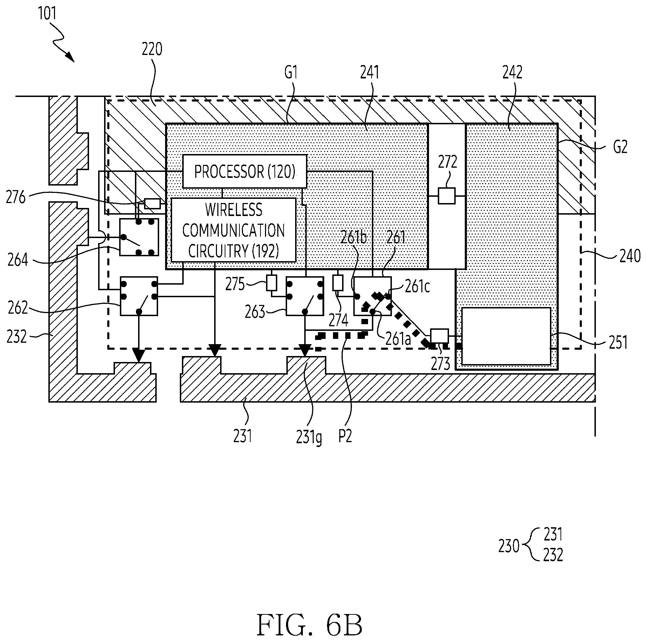

According to an embodiment, the electronic components 251 and 252 may be configured to provide a second ground (e.g., the second ground G2 of FIG. 3) different from the first ground G1. For example, the electronic components 251 and 252 may include a conductive member (e.g., the conductive members 251a and 252a of FIG. 2A) forming an exterior of the electronic components 251 and 252. Referring to FIG. 2A, the connection terminal may include a contact portion 251c in contact with a cable for connection with an external electronic device (e.g., the electronic device 102 of FIG. 1) and a conductive member 251a forming an exterior of the connection terminal. The conductive member 251a may surround the contact portion 251c. The conductive member 251a may be configured to provide a second ground G2, by being connected to the ground layer of the PCB 240 through a connecting member (e.g., the connecting member 271 of FIG. 2B). For example, the speaker and/or microphone may include a conductive member 252a forming an exterior of the speaker and/or microphone, by covering a voice coil and a permanent magnet. The conductive member 252a of the speaker and/or microphone may be configured to provide the second ground G2, by being connected to the ground layer of the PCB 240 through a connecting member 271. According to an embodiment, the second ground G2 may be formed by at least a portion of conductive members 251a and 252a of the electronic components 251 and 252, or may be formed by at least a portion of the conductive members 251a and 252a, and at least a portion of the ground layer of the PCB 240 electrically connected to the conductive members 251a and 252a. The second ground G2 formed by at least a portion of the conductive members 251a and 252a of the electronic components 251 and 252 will be exemplified through FIG. 4B. The second ground G2 formed by at least a portion of conductive members 251a and 252a and at least a portion of the ground layer of the PCB 240 electrically connected to the conductive members 251a and 252a will be exemplified through FIG. 6B. Since the above-described first ground G1 includes a support 220 that is not included in the second ground G2, the first ground G1 may have a size larger than that of the second ground G2.

According to an embodiment, at least a portion of the conductive portion 230 may operate as an antenna radiator for transmitting and/or receiving a signal on a designated band. Wireless communication circuitry (e.g., the wireless communication circuitry 192 of FIG. 4A) may be configured to communicate with an external electronic device (e.g., the electronic device 102 of FIG. 1) through an antenna including at least a portion of the conductive portion 230. When at least a portion of the conductive portion 230 operates as an antenna radiator, the antenna including at least a portion of the conductive portion 230 may be electrically connected to the first ground G1 or the second ground G2. According to an embodiment, radiation performance of the conductive portion 230 may vary according to a size of the ground. For example, a size of the ground to provide higher radiation efficiency for the conductive portion 230 may vary according to a frequency band of a signal transmitted and/or received through the conductive portion 230. For example, a relatively large ground may be suitable for a signal on a relatively low frequency band (e.g., about 600 MHz to about 700 MHz). A relatively small ground may be suitable for a signal on a relatively high frequency band (e.g., about 800 MHz to about 900 MHz). Since the radiation performance may be different according to frequency bands when a ground of the antenna including at least a portion of the conductive portion 230 is fixed, the radiation performance of the conductive portion 230 may be deteriorated in a specific frequency band.

Referring to FIG. 3, the processor 120 may be configured to select a ground for the antenna including at least a portion of the conductive portion 230, through the switch circuit 261. For example, instructions stored in memory (e.g., the memory 130 of FIG. 1), when executed by the processor 120, may cause the electronic device 101 to control the switch circuit 261. The antenna including at least a portion of the conductive portion 230 may be electrically connected to the first ground G1 or the second ground G2 through the switch circuit 261. For example, the switch circuit 261 may be configured to electrically connect the conductive portion 230 to the PCB 240 or the electronic components 251 and 252. For example, the switch circuit 261 may include a first terminal 261a electrically connected to the conductive portion 230, a second terminal 261b electrically connected to the PCB 240, and a third terminal 261c electrically connected to the electronic components 251 and 252. When the first terminal 261a and the second terminal 261b are electrically connected, the antenna including at least a portion of the conductive portion 230 may be electrically connected to the first ground G1 through the switch circuit 261. The first ground G1 may include a ground layer of the PCB 240 and the support 240 electrically connected through the connecting member 277 and/or the support 220 and the conductive sheet 162 electrically connected through the connecting member 278. When the first terminal 261a and the third terminal 261c are electrically connected, the antenna including at least a portion of the conductive portion 230 may be electrically connected to the second ground G2 through the switch circuit 261. In FIG. 3, it is illustrated that the second ground G2 is formed by electronic components 251 and 252, but is not limited thereto. For example, the second ground G2 may include the electronic components 251 and 252 and/or a ground layer of some regions of the PCB 240.

According to an embodiment, the electronic components 251 and 252 may be electrically connected to the PCB 240. For example, the electronic components 251 and 252 may be electrically connected to a ground of the PCB 240 through the connecting member 271. For example, the connecting member 271 may include a capacitor. The electronic components 251 and 252 may be electrically connected to other components of the electronic device 101 through the PCB 240. For example, the connection terminal, the speaker, and/or the microphone may be electrically connected to the processor 120 through the PCB 240. The connecting member 271 may have a capacitance value such that the second ground G2 formed through the electronic components 251 and 252 may operate as a separate ground different from the first ground G1. For example, the connecting member 271 may have a capacitance value that allows only signals on a specified frequency band to pass through. Since the first ground G1 and the second ground G2 may be distinguished by the connecting member 271 even when the electronic components 251 and 252 are electrically connected to a wiring of the PCB 240 for signal transmission, the antenna including at least a portion of the conductive portion 230 may be selectively electrically connected to one of the first ground G1 or the second ground G2.

According to an embodiment, when the wireless communication circuitry 192 transmits or receives a signal on a first frequency band (e.g., about 600 MHz to about 700 MHz), the processor 120 may control the switch circuit 261 to electrically connect the conductive portion 230 and the ground layer of the PCB 240. When the wireless communication circuitry 192 transmits or receives a signal on a second frequency band (e.g., about 800 MHz to about 900 MHz) higher than the first frequency band, the processor 120 may control the switch circuit 261 to electrically connect the conductive portion 230 and the electronic components 251 and 252. The electronic device 101 may improve radiation performance by selecting a ground for increasing signal gain of a specific frequency band through an operation of the switch circuit 261 by the processor 120.

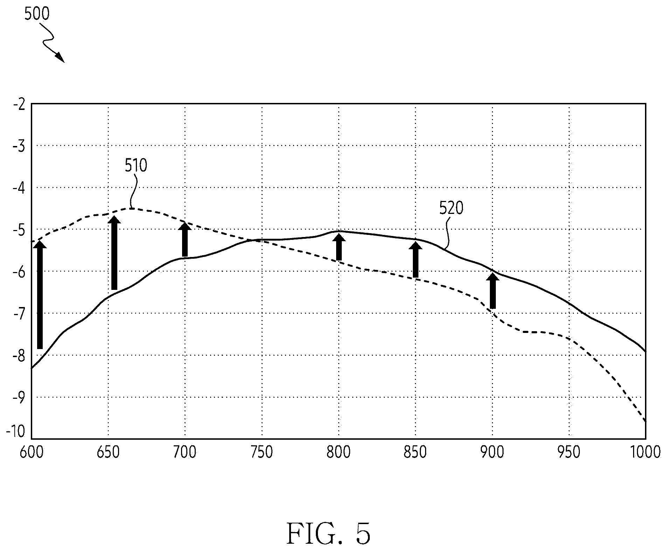

FIG. 4A schematically illustrates a state in which the electronic device 101 transmits or receives a signal on a first frequency band. FIG. 4B schematically illustrates a state in which the electronic device 101 transmits or receives a signal on a second frequency band. FIG. 5 is a graph 500 indicating a radiation characteristic of an antenna according to a frequency band and a ground.

Referring to FIGS. 4A and 4B, the electronic device 101 according to an embodiment may be electrically connected to a ground layer of the PCB 240 through a connecting member 271. The conductive portion 230 may be electrically connected to the ground layer of the PCB 240 or the electronic component 251 through the first switch circuit 261. For example, a ground portion 231g of the conductive portion 230 may be electrically connected to the first switch circuit 261. The ground portion 231g may be electrically connected, through the first switch circuit 261, to the ground layer of the PCB 240 or to the electronic component 251. When the ground portion 231g is electrically connected to the ground layer of the PCB 240, the antenna including at least a portion of the conductive portion 230 may be electrically connected to the first ground G1. When the ground portion 231g is electrically connected to the electronic component 251, the antenna including at least a portion of the conductive portion 230 may be electrically connected to the second ground G2.

According to an embodiment, the conductive portion 230 may have a length based on a frequency band of a signal to be transmitted and/or received through the conductive portion 230. For example, the length of the conductive portion 230 may correspond to about 1/4 to 1/2 wavelength of a wavelength corresponding to a resonant frequency of the signal to be transmitted and/or received. As the length of the conductive portion 230 is adjusted, the conductive portion 230 may operate as an antenna radiator for transmitting and/or receiving a signal on a designated frequency band.

According to an embodiment, the conductive portion 230 operating as an antenna radiator may be positioned along at least a portion of the first periphery 211. For example, the conductive portion 230 may include a first conductive portion 231 and/or a second conductive portion 232 positioned along at least a portion of the first periphery 211. The PCB 240 may be referred to as a second PCB (e.g., the second PCB 240b of FIG. 2A) adjacent to the conductive portion 230. For example, the PCB 240 may be referred to as a second PCB 240b that is closer to the first periphery 211 among the first periphery 211 and a second periphery (e.g., the second periphery 212 of FIG. 2A). The electronic component 251 may be adjacent to the conductive portion 230. For example, the electronic component 251 may be closer to the first periphery 211 among the first periphery 211 and the second periphery 212. However, it is not limited thereto.

According to an embodiment, the conductive portion 230 may include a first conductive portion 231 and a second conductive portion 232 electrically disconnected from the first conductive portion 231. For example, the first conductive portion 231 may be positioned along the first periphery 211. For example, a portion of the second conductive portion 232 may be positioned along the first periphery 211, and a remaining portion of the second conductive portion 232 may be positioned along the third periphery 213. The first conductive portion 231 and the second conductive portion 232 may be electrically disconnected from each other.

According to an embodiment, the first conductive portion 231 and the second conductive portion 232 may be electrically connected through a second switch circuit 262. The processor 120 may adjust an electrical length of an antenna radiator by controlling the second switch circuit 262. For example, when the processor 120 controls the second switch circuit 262 to electrically disconnect the first conductive portion 231 and the second conductive portion 232, the first conductive portion 231 and the second conductive portion 232 may operate as an antenna radiator by being electrically disconnected from each other. For example, when the processor 120 controls the second switch circuit 262 to electrically connect the first conductive portion 231 and the second conductive portion 232, the first conductive portion 231 and the second conductive portion 232 may operate as an antenna radiator by being electrically connected to each other.

According to an embodiment, the processor 120 may be configured to control the first switch circuit 261 and/or the second switch circuit 262, based on a frequency band of a signal. For example, the first switch circuit 261 may include a single pole double throw (SPDT) switch, and the second switch circuit 262 may include a single pole four throw ST4T switch, but is not limited thereto. The processor 120 may select a ground for the conductive portion 230 by controlling the first switch circuit 261 according to a frequency band. The processor 120 may adjust a resonant frequency of an antenna including at least a portion of the conductive portion 230, by adjusting an electrical length of the conductive portion 230 according to a frequency band. Referring to FIG. 4A, when the wireless communication circuitry 192 transmits or receives a signal on a first frequency band (e.g., about 600 MHz to about 700 MHz), the processor 120 may control the second switch circuit 262 to electrically disconnect the second conductive portion 232 from the first conductive portion 231. When transmitting or receiving a signal on the first frequency band, the wireless communication circuitry 192 may feed the first conductive portion 231 electrically disconnected from the second conductive portion 232. The first conductive portion 231 may operate as an antenna radiator for transmitting and/or receiving a signal on the first frequency band by being fed by the wireless communication circuitry 192. The wireless communication circuitry 192 may be configured to, through an antenna including the first conductive portion 231, transmit a signal on the first frequency band to an external electronic device (e.g., the electronic device 102 of FIG. 1), or receive a signal on the first frequency band from an external electronic device (e.g., electronic device 102 of FIG. 1).

According to an embodiment, when the wireless communication circuitry 192 transmits or receives a signal on the first frequency band, the processor 120 may control the first switch circuit 261 to electrically connect the first conductive portion 231 and a ground layer of the PCB 240. The first switch circuit 261 may be electrically connected to the ground layer of the PCB 260 through a connecting member 274. For example, the connecting member 274 may include a matching element for adjusting a resonant frequency of an antenna including the first conductive portion 231. For example, the processor 120 may control the first switch circuit 261 to connect the first terminal 261a and the second terminal 261b. The first conductive portion 231 may be electrically connected to the ground layer of the PCB 240 through the first switch circuit 261. The antenna including the first conductive portion 231 may be electrically connected to a first ground (e.g., the first ground G1 of FIG. 3) by being electrically connected to the support 220 and/or a conductive sheet (e.g., the conductive sheet 162 of FIG. 2B) through the ground layer of the PCB 240.

According to an embodiment, when the antenna including the first conductive portion 231 is electrically connected to the first ground G1, a path P1 of a current flowing to a ground may be formed from a ground portion 231g of the first conductive portion 231 along the first switch circuit 261, the ground layer of the PCB 240, the support 220, and/or the conductive sheet 162. The first ground G1 having a relatively large size may be configured to provide a ground for a signal on a first frequency band, which is a relatively low frequency band. The wireless communication circuitry 192 may transmit and/or receive a signal on the first frequency band through an antenna including the first conductive portion 231 electrically connected to the first ground G1.

According to an embodiment, the electronic device 101 may further include switch circuits for an antenna including at least a portion of the conductive portion 230. For example, the antenna including the first conductive portion 231 may be electrically connected to the first ground G1 through a third switch circuit 263 different from the first switch circuit 261. For example, the third switch circuit 263 may be electrically connected to the ground portion 231g of the first conductive portion 231 and the ground layer of the PCB 240. The third switch circuit 263 may be electrically connected to the ground layer of the PCB 260 through a connecting member 275. For example, the connecting member 275 may include a matching element for adjusting a resonant frequency of an antenna including the first conductive portion 231. When the ground portion 231g is electrically connected to the ground layer of the PCB 240 through the third switch circuit 263, the antenna including the first conductive portion 231 may be electrically connected to the first ground G1. When the ground portion 231g is electrically connected to the first ground G1 through the third switch circuit 263, a path P1 of a current flowing to a ground may be formed from the ground portion 231g of the first conductive portion 231 along the first switch circuit 261, the ground layer of the PCB 240, the support 220, and/or the conductive sheet 162.

Referring to FIG. 4B, when the wireless communication circuitry 192 transmits or receives a signal on a second frequency band (e.g., about 800 MHz to 900 MHz) higher than the first frequency band, the processor 120 may control the second switch circuit 262 to electrically connect the second conductive portion 232 to the first conductive portion 231. The wireless communication circuitry 192 may transmit or receive a signal on the second frequency band through the first conductive portion 231 and the second conductive portion 232 electrically connected to each other. The first conductive portion 231 and the second conductive portion 232 may operate as an antenna radiator for transmitting and/or receiving a signal on the second frequency band higher than the first frequency band by being electrically connected to each other. However, it is not limited thereto. For example, when the wireless communication circuitry 192 transmits or receives a signal on the second frequency band, the processor 120 may control the second switch circuit 262 to electrically disconnect the second conductive portion 232 from the first conductive portion 231. The wireless communication circuitry 192 may be configured to, through an antenna including the first conductive portion 231 and/or the second conductive portion 232, transmit a signal on the second frequency band to an external electronic device (e.g., the electronic device 102 of FIG. 1) or receive a signal on the second frequency band from the external electronic device 102.

According to an embodiment, when the wireless communication circuitry 192 transmits or receives a signal on the second frequency band, the processor 120 may control the first switch circuit 261 to electrically connect the first conductive portion 231 and the electronic component 251. The first switch circuit 261 may be electrically connected to the electronic component 251 through a connecting member 273. For example, the connecting member 273 may include a capacitor. For example, the processor 120 may control the first switch circuit 261 to connect a first terminal 261a and a third terminal 261c. The first conductive portion 231 may be electrically connected to the electronic component 251 through the first switch circuit 261. The antenna including the first conductive portion 231 may be electrically connected to a second ground (e.g., the second ground G2 of FIG. 3) provided by the electronic component 251. For example, the antenna including the first conductive portion 231 may be electrically connected to a conductive member (e.g., the conductive member 251a of FIG. 2A) of the electronic component 251.

According to an embodiment, when the antenna including the first conductive portion 231 is electrically connected to the second ground G2, a path P2 of a current flowing to a ground may be formed from a ground portion 231g of the first conductive portion 231 along the first switch circuit 261 and the electronic component 251. In a state that the first switch circuit 261 electrically connects the first conductive portion 231 to the electronic component 251, since a resistance of the second ground G2 having a relatively small size is small even when the first conductive portion 231 and the first ground G1 are electrically connected, the current may be formed along the second ground G2. The second ground G2 having a relatively small size may be configured to provide a ground for a signal on the second frequency band, which is a relatively high frequency band. The wireless communication circuitry 192 may transmit and/or receive a signal on the second frequency band through an antenna including the first conductive portion 231 and/or the second conductive portion 232 electrically connected to the second ground G2.

According to an embodiment, the electronic component 251 may be electrically connected to a ground of the PCB 240 through a first connecting member 271. For example, the first connecting member 271 may include a capacitor. The electronic component 251 may be electrically connected to the PCB 240 so that the electronic component 251 may be electrically connected to another component (e.g., the processor 120) of the electronic device 101 through the PCB 240. According to an embodiment, the PCB 240 and the electronic component 251 may be separated for a radio frequency (RF) signal on a designated frequency band through the first connecting member 271. For example, the first connecting member 271 may be configured to separate a low-frequency band signal, in order to separate a DC power ground of an external electronic device (e.g., charger) from a DC power ground of the electronic device 101. As the PCB 240 and the electronic component 251 are separated for an RF signal on a designated frequency band, the RF signal may not be transmitted through the first connecting member 271 between the PCB 240 and the electronic component 251. The first connecting member 271 may have a designated capacitance value so that the second ground G2 provided by the electronic component 251 may function as a ground different from the first ground G1. For example, when the electronic component 251 provides the second ground G2 for a signal on the second frequency band, the first connecting member 271 may have a capacitance value for blocking a signal outside the second frequency band from being provided to the PCB 240 through the first connecting member 271 from the electronic component 251. Even when the electronic component 251 is electrically connected to the ground layer of the PCB 240 through the first connecting member 271, the second ground G2 provided by the electronic component 251 may operate as a ground different from the first ground G1.

According to an embodiment, the wireless communication circuitry 192 may fed a second conductive portion 232 through the second switch circuit 262, in a state that the second conductive portion 232 is electrically disconnected from the first conductive portion 231. The second conductive portion 232 may operate as an antenna radiator for transmitting and/or receiving a signal on a designated frequency band by being fed by the wireless communication circuitry 192. An antenna including the second conductive portion 232 may be electrically connected to the ground layer of the PCB 240 through a fourth switch circuit 264. For example, the fourth switch circuit 264 may be electrically connected to the ground layer of the PCB 240 through a connecting member 276. According to an embodiment, various antennas may be implemented using a segmental structure of the conductive portion 230.

Referring to FIG. 5, when an antenna including a first conductive portion (e.g., the first conductive portion 231 of FIG. 4A) and/or a second conductive portion (e.g., the second conductive portion 232 of FIG. 4A) transmits and/or receives a signal on the second frequency band, it is confirmed that a radiation characteristic change due to being electrically connected to a first ground (e.g., the first ground G1 of FIG. 3) or a second ground (e.g., the second ground G2 of FIG. 3). In a graph 500, the x-axis is a frequency (unit: megahertz (MHz)) of a signal, and the y-axis is a gain (unit: decibel (dB)) of an antenna. A first graph 510 of FIG. 5 illustrates a radiation characteristic according to a frequency band, in a state that the antenna including the first conductive portion 231 and/or the second conductive portion 232 is electrically connected to the first ground G1. A second graph 520 of FIG. 5 illustrates a radiation characteristic according to a frequency band, in a state that the antenna including the first conductive portion 231 and/or the second conductive portion 232 is electrically connected to the second ground G2.

Referring to the first graph 510 of FIG. 5, in a state that the antenna including the first conductive portion 231 and/or the second conductive portion 232 is electrically connected to the first ground G1, the antenna may have a relatively high gain for a signal on a relatively low frequency band and a relatively low gain for a signal on a relatively high frequency band. In a state that the antenna is electrically connected to the first ground G1, it may have a relatively high gain (e.g., about -5 dB or more) for a signal having a frequency between about 600 MHz and about 700 MHz. In a state that the antenna is electrically connected to the first ground G1, it may have a relatively low gain (e.g., about -7 dB or less) for a signal having a frequency of about 900 MHz or more.

Referring to the second graph 520 of FIG. 5, in a state that the antenna including the first conductive portion 231 and/or the second conductive portion 232 is electrically connected to the second ground G2, the antenna may have a relatively high gain for a signal on a relatively high frequency band and a relatively low gain for a signal on a relatively low frequency band. The second graph 520 may have a relatively higher gain (e.g., about -6 dB or more) for a signal having a frequency between about 800 MHz and about 900 MHz compared to the first graph 510. In a signal on a frequency band between about 800 MHz and about 900 MHz, the antenna may have improved communication performance when electrically connected to the second ground G2.

According to an embodiment, the electronic device 101 may include a first ground G1 and a second ground G2 different from each other. According to an embodiment, the processor 120 may improve the radiation performance of an antenna by selecting a ground of the antenna including the first conductive portion 231 and/or the second conductive portion 232 based on a frequency band. For example, when the wireless communication circuitry 192 transmits or receives a signal on a first frequency band (e.g., about 600 MHz to about 700 MHz), the processor 120 may ground the antenna to the first ground G1 having a relatively large size by controlling the first switch circuit 261. When the wireless communication circuitry 192 transmits or receives a signal on a second frequency band (e.g., about 800 MHz to about 900 MHz) higher than the first frequency band, the processor 120 may ground the antenna to the second ground G2 having a relatively small size by controlling the first switch circuit 261. As illustrated in FIG. 5, for a signal on the first frequency band, the antenna electrically connected to the first ground G1 may have a gain about 1dB to about 3dB higher than the antenna electrically connected to the second ground G2. For a signal on the second frequency band, the antenna electrically connected to the second ground G2 may have a gain about 1 dB higher than the antenna electrically connected to the first ground G1. According to an embodiment, since a ground for the antenna may be selected as a ground for providing higher radiation efficiency according to a frequency band, the electronic device 101 may have improved communication performance.

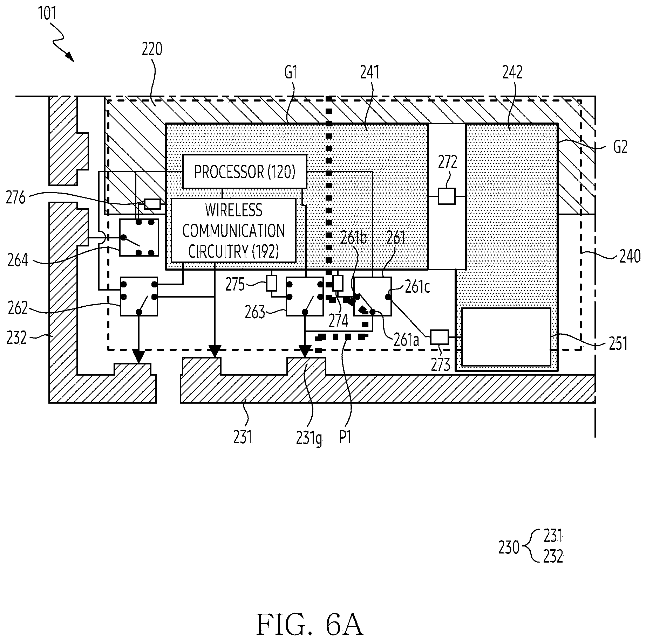

FIG. 6A schematically illustrates a state in which an electronic device 101 transmits or receives a signal on a first frequency band. FIG. 6B schematically illustrates a state in which an electronic device 101 transmits or receives a signal on a second frequency band.

The exemplary electronic device 101 illustrated in FIGS. 6A and 6B may include an electronic component 251 electrically connected to a ground layer of the PCB 240. The components illustrated in FIGS. 6A and 6B may be substantially the same as the components illustrated in FIGS. 4A and 4B, and overlapping descriptions may be omitted.

Referring to FIGS. 6A and 6B, the ground layer of the PCB 240 may include a first region 241 and a second region 242 different from the first region 241. The second region 242 may be separated from the first region 241. A second connecting member 272 may electrically connect the first region 241 and the second region 242 separated from each other.

In an embodiment, the first region 241 may be electrically connected to the support 220. For example, a component of the electronic device 101 electrically connected to the first region 241 may be electrically connected to the support 220 and/or a conductive sheet (e.g., the conductive sheet 162 of FIG. 2B) through the first region 241. A ground formed by the first region 241 of the PCB 240, the support 220, and/or the conductive sheet 162 electrically connected to each other may be referred to as a first ground G1. The first ground G1 may include the first region 241, the support 220, and/or the conductive sheet 162.

According to an embodiment, the electronic component 251 may be electrically connected to the second region 242. For example, the second region 242 of the PCB 240 and the electronic component 251 electrically connected to each other may be configured to provide a second ground G2.

According to an embodiment, a conductive portion 230 (e.g., the first conductive portion 231) may be electrically connected to the first region 241 or the electronic component 251, through the first switch circuit 261. For example, a ground portion 231g of the conductive portion 230 may be electrically connected to the first switch circuit 261. The first switch circuit 261 may include a first terminal 261a electrically connected to the conductive portion 230, a second terminal 261b electrically connected to the first region 241 of the PCB 240, and a third terminal 261c electrically connected to the electronic component 251. The conductive portion 230 may be electrically connected to the first region 241 when the first terminal 261a and the second terminal 261b are connected, and the conductive portion 230 may be electrically connected to the electronic component 251 when the first terminal 261a and the third terminal 261c are connected.

Referring to FIG. 6A, when the wireless communication circuitry 192 transmits or receives a signal on a first frequency band (e.g., about 600 MHz to about 700 MHz), the processor 120 may control the first switch circuit 261 to electrically connect the conductive portion 230 and the first region 241. For example, the processor 120 may control the first switch circuit 261 so that the first terminal 261a and the second terminal 261b are connected. The conductive portion 230 may be electrically connected to the first region 241 through the first switch circuit 261. The conductive portion 230 may be electrically connected to the first ground G1 by being electrically connected to the support 220 and/or the conductive sheet 162 through a first region within the first region 241.

According to an embodiment, when the conductive portion 230 is electrically connected to the first ground G1, a path P1 of a current flowing to a ground may be formed from the ground portion 231g of the conductive portion 230 along the first switch circuit 261, the first region 241, the support 220, and/or the conductive sheet 162. The first ground G1 having a relatively large size may be configured to provide a ground for a signal on the first frequency band, which is a relatively low frequency band. The wireless communication circuitry 192 may transmit and/or receive a signal on the first frequency band through the conductive portion 230 electrically connected to the first ground G1.

Referring to FIG. 6B, when the wireless communication circuitry 192 transmits or receives a signal on a second frequency band, the processor 120 may control the first switch circuit 261 to electrically connect a conductive portion 230 (e.g., the first conductive portion 231) and the electronic component 251. For example, the processor 120 may control the first switch circuit 261 so that the first terminal 261a and the third terminal 261c are connected. The conductive portion 230 may be electrically connected to the electronic component 251 through the first switch circuit 261. The conductive portion 230 may be connected to a second ground G2 provided by the electronic component 251 and the second region 242.

According to an embodiment, the second region 242 of the PCB 240 and the electronic component 251 may be connected, and a second connecting member 272 may be disposed between the second region 242 and the first region 241. By the second connecting member 272, the first region 241 and the second region 242 may be distinguished as separate regions with respect to a RF signal. The second connecting member 272 may have a designated capacitance value so that the second ground G2 provided by the electronic component 251 and the second region 242 in the second region 242 may function as a ground different from the first ground G1. For example, when the electronic component 251 and the second regions 242 provide a second ground G2 for a signal on the second frequency band, the second connecting member 272 may have a capacitance value for blocking a signal outside the second frequency band from being provided from the second region 242 to the first region 241 through the second connecting member 272. Even when the first region 241 and the second region 242 are electrically connected through the second connecting member 272, the second ground G2 may operate as a ground different from the first ground G1.

According to an embodiment, when the conductive portion 230 is electrically connected to the second ground G2, a path P2 of a current flowing to a ground may be formed from the ground portion 231g of the conductive portion 230 along the first switch circuit 261, the electronic component 251, and the second region 242. In a state that the first switch circuit 261 electrically connects the conductive portion 230 and the electronic component 251, since a resistance of the second ground G2 having a relatively small size is small even when the conductive portion 230 and the first ground G1 are electrically connected, the current may be formed along the second ground G2. The second ground G2 having a relatively small size may be configured to provide a ground for a signal on the second frequency band, which is a relatively high frequency band. The wireless communication circuitry 192 may transmit and/or receive a signal on the second frequency band through the first conductive portion 231 and/or the second conductive portion 232 electrically connected to the second ground G2.

In a case of the electronic device 101 illustrated in FIG. 4B, the electronic component 251 and the PCB 240 may be distinguished as separated regions for a RF signal through the first connecting member 271, and the second ground G2 may be formed only of a conductive member (e.g., the conductive member 251a of FIG. 2A) of the electronic component 251. Alternatively, according to the embodiments of FIGS. 6A and 6B, the second ground G2 may be referred to as the conductive member 251a of the electronic component 251 and the second region 242. In a case of the electronic device 101 illustrated in FIG. 6B, since the second ground G2 further includes a ground layer in some region (e.g., the second region 242) of the PCB 240, it may have a size larger than that of the second ground G2 of the electronic device 101 illustrated in FIG. 4B. When a size of the second ground G2 is additionally required, the second ground G2 may provide a second ground G2 for an antenna including at least a portion of the conductive portion 230 by including a ground layer in some region of the PCB 240 in addition to the electronic component 251.

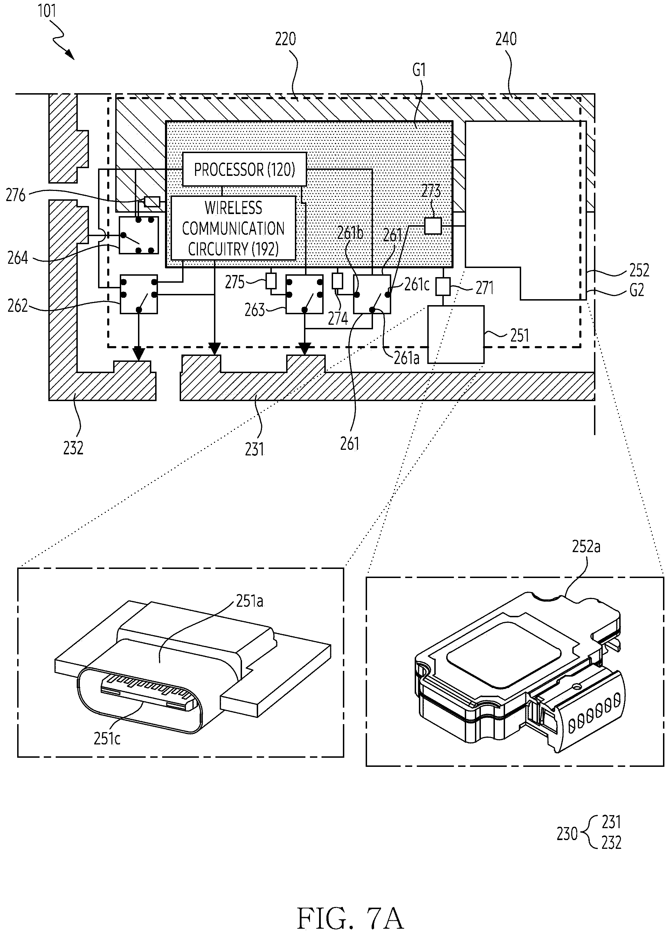

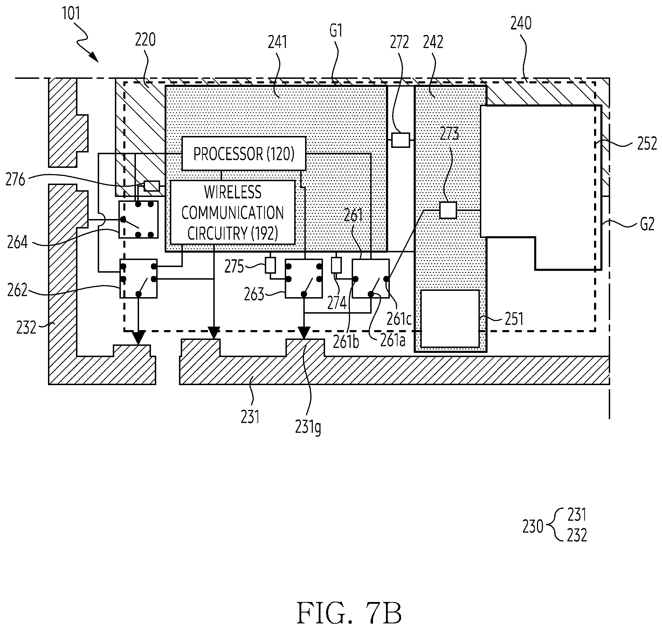

FIGS. 7A and 7B schematically illustrate a state in which an electronic device 101 provides a ground by using a plurality of electronic components 251 and 252.

Referring to FIGS. 7A and 7B, the electronic device 101 according to an embodiment may include a plurality of electronic components 251 and 252 that provide the second ground G2. For example, the electronic device 101 may include a first electronic component 251 and/or a second electronic component 252. According to an embodiment, the first electronic component 251 may be electrically connected to a ground layer of the PCB 240 through a first connecting member 271. For example, the first electronic component 251 may include a connection terminal to which a cable of an external electronic device (e.g., charger) may be connected. For example, the first connecting member 271 may be configured to separate a DC power ground of an external electronic device (e.g., charger) and a DC power ground of the electronic device 101 to prevent an electric shock.

Referring to FIG. 7A, the first switch circuit 261 may be configured to electrically connect the conductive portion 230 to any one of a ground layer of the PCB 240 or a plurality of electronic components 251 and 252. For example, the first switch circuit 261 may include a first terminal 261a electrically connected to the conductive portion 230, a second terminal 261b electrically connected to the ground layer of the PCB 240, and a third terminal 261c electrically connected to the second electronic component 252. The conductive portion 230 may be electrically connected to the ground layer of the PCB 240 when the first terminal 261a and the second terminal 261b are connected, and the conductive portion 230 may be electrically connected to the second electronic component 252 when the first terminal 261a and the third terminal 261c are connected. The first switch circuit 261 may be electrically connected to the second electronic component 252 through the connecting member 273.

According to an embodiment, the first electronic component 251 and the second electronic component 252 may have different sizes. For example, a size of the second electronic component 252 (e.g., speaker) may be larger than a size of the first electronic component 251 (e.g., connection terminal). For example, a size of a second conductive member 252a forming an exterior of the second electronic component 252 may be larger than a size of a first conductive member 251a forming an exterior of the first electronic component 251. Since the size of the first electronic component 251 and the size of the second electronic component 252 are different, a size of the second ground G2 formed by the second electronic component 252 may be larger than a size of the second ground G2 formed by the first electronic component 251.

According to an embodiment, the electronic device 101 may include the first ground G1 and the second ground G2 having different sizes. For example, the first ground G1 may include a ground layer of the PCB 240, the support 220, and/or a conductive sheet (e.g., the conductive sheet 162 of FIG. 2B). For example, the second ground G2 may include a second electronic component 252. The processor 120 may improve the radiation performance of an antenna by selecting a ground of the antenna including the first conductive portion 231 and/or the second conductive portion 232 based on a frequency band. For example, when the wireless communication circuitry 192 transmits or receives a signal on a first frequency band (e.g., about 600 MHz to 700 MHz), the processor 120 may control the first switch circuit 261 to electrically connect the conductive portion 230 and a ground layer of the PCB 240. For example, the processor 120 may control the first switch circuit 261 so that the first terminal 261a and the second terminal 261b are connected. An antenna including at least a portion of the conductive portion 230 may be electrically connected to the first ground G1 provided by the PCB 240, the support 220 and/or the conductive sheet 162.

According to an embodiment, when the wireless communication circuitry 192 transmits or receives a signal on a second frequency band (e.g., about 800 MHz to about 900 MHz), the processor 120 may control the first switch circuit 261 to electrically connect the conductive portion 230 and the second electronic component 252. For example, the processor 120 may control the first switch circuit 261 so that the first terminal 261a and the third terminal 261c are connected. The conductive portion 230 may be electrically connected to the second electronic component 252 through the first switch circuit 261. An antenna including at least a portion of the conductive portion 230 may be electrically connected to the second ground G2 provided by the second electronic component 252. For example, an antenna including the first conductive portion 231 and/or the second conductive portion 232 may be electrically connected to the second conductive member 252a of the second electronic component 252. According to an embodiment, since the ground for the antenna may be selected as a ground for providing improved radiation efficiency in a frequency band among a plurality of grounds, the electronic device 101 may have improved communication performance.

Referring to FIG. 7B, the first electronic component 251 and the second electronic component 252 may be electrically connected to the ground layer of the PCB 240. For example, when an electronic component is directly electrically connected to the ground layer of the PCB 240, the first electronic component 251 and the second electronic component 252 may at least partially overlap the PCB 240. In an embodiment, the ground layer of the PCB 240 may include a first region 241, a second region 242 different from the first region 241, and/or a second connecting member 272. The second region 242 separated from the first region 241 may be electrically connected to the first electronic component 251 and the second electronic component 252. The second connecting member 272 may electromagnetically connect the first region 241 and the second region 242 separated from each other. For example, the second connecting member 272 may include a capacitor.

According to an embodiment, the ground layer of the PCB 240 may be distinguished into the first region 241 within the first region 241 and the second region 242 within the second region 242. The first region 241 may be electrically connected to the support 220. For example, a component of the electronic device 101 electrically connected to the first region 241 may be electrically connected to the support 220 and/or a conductive sheet (e.g., the conductive sheet 162 of FIG. 2B) through the first region 241. A ground formed by the first region 241 of the PCB 240, the support 220, and/or a conductive sheet (e.g., the conductive sheet 162 of FIG. 2B) electrically connected to each other may be referred to as a first ground G1. The first ground G1 may include the first region 241, the support 220, and/or the conductive sheet 162.

According to an embodiment, the first electronic component 251 and the second electronic component 252 may be electrically connected to the second region 242. For example, the second ground region of the PCB 240, the first electronic component 251, and the second electronic component 252 electrically connected to each other may be configured to provide a second ground G2. For example, the second ground G2 may include the second ground region within the second region 242, the first conductive member 251a, and the second conductive member 252a.

According to an embodiment, when the wireless communication circuitry 192 transmits or receives a signal on a first frequency band (e.g., about 600 MHz to about 700 MHz), the processor 120 may control the first switch circuit 261 to electrically connect the conductive portion 230 and the first region 241. For example, the processor 120 may control the first switch circuit 261 so that the first terminal 261a and the second terminal 261b are connected. The conductive portion 230 may be electrically connected to the first region 241 through the first switch circuit 261. The conductive portion 230 may be electrically connected to the first ground G1 by being electrically connected to the support 220 and/or the conductive sheet 162 through the first ground region within the first region 241.

According to an embodiment, when the wireless communication circuitry 192 transmits or receives a signal on the second frequency band, the processor 120 may control the first switch circuit 261 to electrically connect the conductive portion 230 with one of the first electronic component 251 and the second electronic component 252. For example, the processor 120 may control the first switch circuit 261 so that the first terminal 261a and the third terminal 261c are connected. The conductive portion 230 may be electrically connected to the second electronic component 252 through the first switch circuit 261. Since the second electronic component 252 is electrically connected to the second ground region electrically connected to the first electronic component 251, the conductive portion 230 may be electrically connected to the second ground G2 provided by the first conductive member 251a, the second conductive member 252a, and the second ground region.

According to an embodiment, when the conductive portion 230 is electrically connected to the second ground G2, the second ground G2 having a relatively small size may be configured to provide a ground for a signal on the second frequency band, which is a relatively high frequency band. The wireless communication circuitry 192 may transmit and/or receive a signal on the second frequency band through the first conductive portion 231 and/or the second conductive portion 232 electrically connected to the second ground G2.

In a case of the electronic device 101 illustrated in FIG. 6B, the second ground G2 may be formed by the first electronic component 251 and the second ground region within the second region 242. In a case of the electronic device 101 illustrated in FIG. 7B, the second ground G2 may be formed by the first electronic component 251, the second electronic component 252, and the second ground region within the second region 242. According to an embodiment, since the second ground G2 includes a plurality of electronic components 251 and 252, the second ground G2 may have a size larger than that of a case including only one electronic component (e.g., the first electronic component 251). When a ground for an antenna uses the second ground G2 having a relatively small size, the size of the second ground G2 may be changed by a plurality of electronic components and some regions (e.g., the second region 242) of the PCB 240. According to an embodiment, when it is required to increase the size of the second ground G2, the electronic device 101 may use another electronic component (e.g., the second electronic component 252) connected to the PCB 240. As the size of the second ground G2 increases, the electronic device 101 may select a ground for providing higher radiation efficiency for a signal on a specific frequency band.

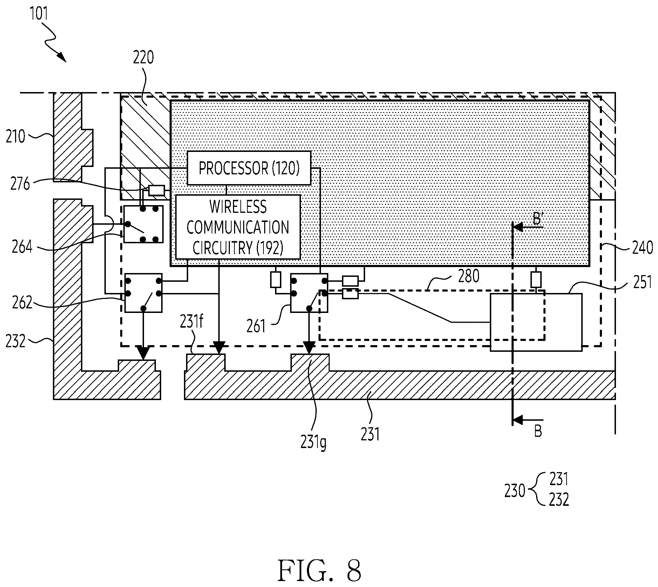

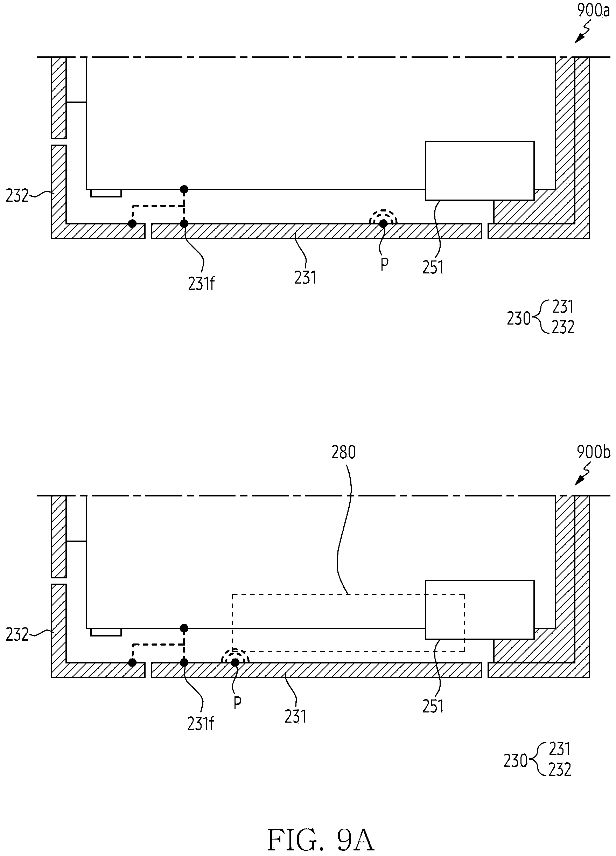

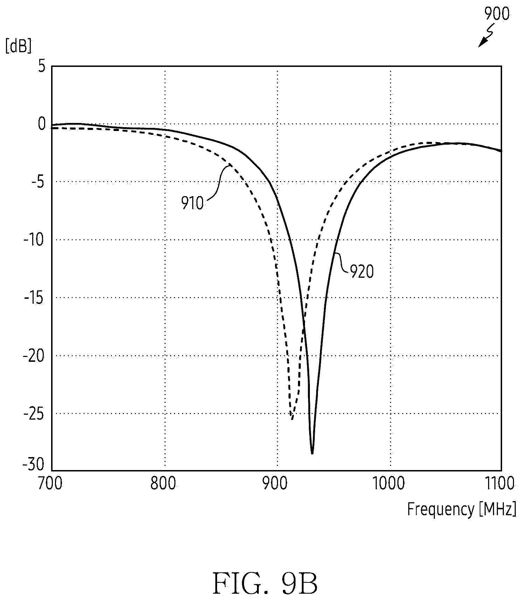

FIG. 8 schematically illustrates an exemplary electronic device including a conductive member for changing a coupling position between a conductive portion and an electronic component. FIG. 9A illustrates a position of a feeding portion and a coupling point within a conductive portion of an exemplary electronic device. FIG. 9B is a graph indicating a radiation characteristic of an antenna including at least a portion of a conductive portion of FIG. 9A.

Referring to FIG. 8, a conductive portion 230 (e.g., the first conductive portion 231) positioned at a periphery of the housing 210 may be adjacent to the electronic component 251 within the housing 210. As the conductive portion 230 and the electronic component 251 are adjacent to each other, the conductive portion 230 and the electronic component 251 may be coupled to each other. For example, the conductive portion 230 and a conductive member (e.g., the conductive member 251a of FIG. 2A) forming an exterior of the electronic component 251 may be disposed within a distance capable of causing an electromagnetic interaction with each other. The interaction between the conductive portion 230 and the electronic component 251 may form a coupling point (e.g., the coupling point P of FIG. 9A) at a specific position within the conductive portion 230.

According to an embodiment, the electronic device 101 may further include a conductive member 280. The conductive member 280 may at least partially overlap the electronic component 251. The conductive member 280 may be used to change a coupling position between the conductive portion 230 and the electronic component 251.

According to an embodiment, the ground portion 231g of the conductive portion 230 may be electrically connected to the electronic component 251. For example, the ground portion 231g may be electrically connected to the electronic component 251 through the first switch circuit 261. In a state that the electronic component 251 is electrically connected to the ground portion 231g within the conductive portion 230, the conductive member 280 may be configured to change a position of the coupling point P between the conductive portion 230 and the electronic component 251.

According to an embodiment, the conductive portion 230 positioned at a periphery of the housing 210 may be adjacent to the electronic component 251 within the housing 210. As the conductive portion 230 and the electronic component 251 are adjacent to each other, the conductive portion 230 and the electronic component 251 may be coupled to each other. For example, the conductive portion 230 and a conductive member (e.g., the conductive member 251a of FIG. 2A) forming an exterior of the electronic component 251 may be disposed within a distance capable of causing an electromagnetic interaction with each other. The interaction between the conductive portion 230 and the electronic component 251 may form a coupling point P at a specific position within the conductive portion 230.

According to an embodiment, the conductive portion 230 may operate as an antenna radiator. For example, as the wireless communication circuitry 192 feeds a feeding portion 231f of the conductive portion 230, an antenna including at least a portion of the conductive portion 230 may be formed. When the conductive portion 230 operates as an antenna radiator, the coupling point P formed within the conductive portion 230 may affect a resonant frequency of the antenna including at least a portion of the conductive portion 230. For example, according to a positional relationship between the feeding portion 231f within the conductive portion 230 and the coupling point P, it may be difficult to form a resource frequency in a specific frequency band.

According to an embodiment, the conductive member 280 may be configured to change a position of the coupling point P between the conductive portion 230 formed within the conductive portion 230 and the electronic component 251. In an embodiment, the conductive member 280 may be disposed to be coupled to the conductive portion 230 and to overlap the electronic component 251. The conductive member 280 may be coupled to the electronic component 251 and/or the conductive portion 230, thereby changing a coupling position within the conductive portion 230.

According to an embodiment, since the wireless communication circuitry 192 may feed the feeding portion 231f at a designated position within the conductive portion 230, a position of the feeding portion 231f within the conductive portion 230 may be constant. A relative position of the coupling point P due to the coupling between the electronic component 251 and the conductive portion 230 may be different according to the design inside the electronic device 101. 900a of FIG. 9A indicates a conductive portion 230 (e.g., the first conductive portion 231) of the electronic device 101 that does not include the conductive member 280. Referring to 900a of FIG. 9A, a distance between the feeding portion 231f and the coupling point P within the conductive portion 230 may be relatively far. 900b of FIG. 9A indicates a conductive portion 230 (e.g., the first conductive portion 231) of the electronic device 101 including the conductive member 280. Referring to 900b of FIG. 9A, a distance between the feeding portion 231f and the coupling point P within the conductive portion 230 may be relatively close.

Referring to FIG. 9B, a radiation characteristic change of an antenna including at least a portion of the conductive portion 230 may be confirmed according to a position of the coupling point P formed at the conductive portion 230. In the graph 900, the x-axis is a frequency (unit: MHz) of a signal, and the y-axis is a gain (unit: dB) of an antenna.

The first graph 910 of FIG. 9B illustrates a gain according to a frequency of an antenna including at least a portion of the conductive portion 230, in the electronic device 101 illustrated in 900a of FIG. 9A, which does not include the conductive member 280. The second graph 920 of FIG. 9B illustrates a gain according to a frequency of an antenna including at least a portion of the conductive portion 230, in the electronic device 101 illustrated in 900b of FIG. 9A, which does not include the conductive member 280.

Referring to the first graph 910 and the second graph 920, a resonant frequency of an antenna including at least a portion of the conductive portion 230 of 900a may be lower than a resonant frequency of an antenna including at least a portion of the conductive portion 230 of 900b. When a distance between the feeding portion 231f within the conductive portion 230 and the coupling point P is relatively far, a resonant frequency of an antenna including at least a portion of the conductive portion 230 may be low-shifted. In order to compensate for a low shift of the resonant frequency due to the coupling point P and communicate based on a resonant frequency of about 900 MHz, it may be required to move a position of the coupling point P to a position relatively closer to the feeding portion 231f. The electronic device 101 according to an embodiment may move the position of the coupling point P within the conductive portion 230 to a position relatively close to the feeding portion 231f, by using the conductive member 280.

According to an embodiment, the wireless communication circuitry 192 may be configured to communicate with an external electronic device (e.g., the electronic device 102 of FIG. 1) based on a resonant frequency corresponding to the coupling position changed by the conductive member 280, in a state in which the conductive portion 230 and the electronic component 251 are electrically connected through the switch circuit 261. For example, when the wireless communication circuitry 192 communicates with the external electronic device 102 based on a resonant frequency of about 900 MHz, the conductive member 280 may change the coupling position within the conductive portion 230. When the conductive member 280 is not included, it may be difficult to form a resonant frequency of about 900 MHz due to coupling between the conductive portion 230 and the electronic component 251. The conductive member 280 may move the coupling position to a position relatively close to the feeding position 231f within the conductive portion 230. As the coupling position within the conductive portion 230 moves to a position relatively close to the feeding portion 231f, the antenna including at least a portion of the conductive portion 230 may compensate for the low shift of the resonant frequency due to the coupling between the electronic component 251 and the conductive portion 230, thereby forming a resonant frequency of about 900 MHz. For example, when the wireless communication circuitry 192 transmits or receives a signal on the E-GSM band (900 MHz) defined by the International Telecommunication Union (ITU) or in the B8 band (e.g., DL: 925-960 MHz, UL: 880-915 MHz) defined by 3GPP, the conductive member 280 may high-shift a resonant frequency of an antenna including at least a portion of the conductive portion 230 by moving the coupling point P within the conductive portion 230.

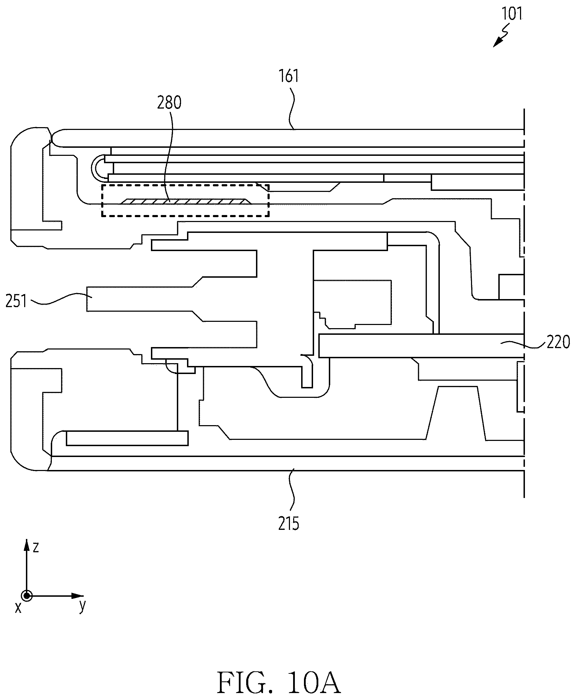

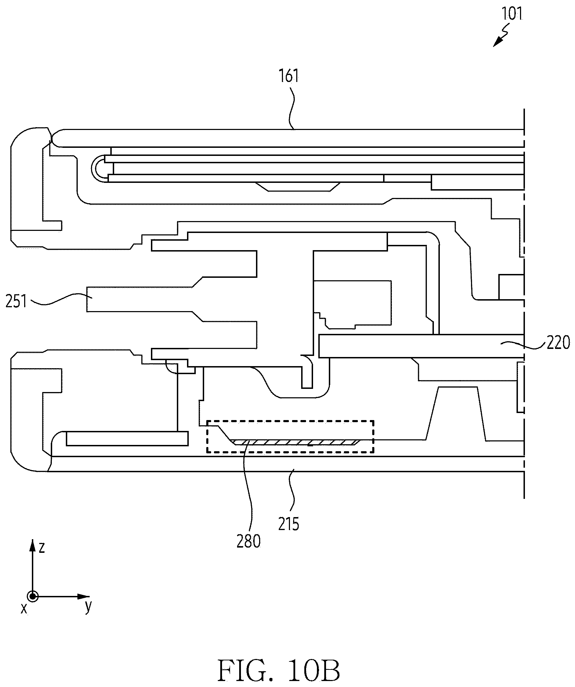

FIGS. 10A and 10B schematically illustrate a cross section of an exemplary electronic device cut along B-B' of FIG. 8.

The electronic device 101 according to an embodiment may include a display 161 and a cover plate 215 facing opposite each other. The display 161 may be disposed on a side (e.g., +z direction) of the support 220, and the cover plate 215 may be disposed on another side (e.g., -z direction) of the support 220.

According to an embodiment, the conductive member 280 may overlap the electronic component 251 to couple to the electronic component 251. The conductive member 280 overlapping the electronic component 251 may be positioned in various positions. Referring to FIG. 10A, the conductive member 280 may be positioned between the electronic component 251 and the display 161. Referring to FIG. 10B, the conductive member 280 may be positioned between the electronic component 251 and the cover plate 215. As the conductive member 280 overlapping the electronic component 251 is coupled to the electronic component 251, regardless of its position, it may be configured to change a position of a coupling point (e.g., the coupling point P of FIG. 9A) within the conductive portion 230.

According to an embodiment, the conductive member 280 may be implemented in various forms. For example, the conductive member 280 may be a conductive tape, a conductive sheet, or a conductive plate including a conductive material (e.g., metal) for coupling with the electronic component 251, but is not limited thereto.

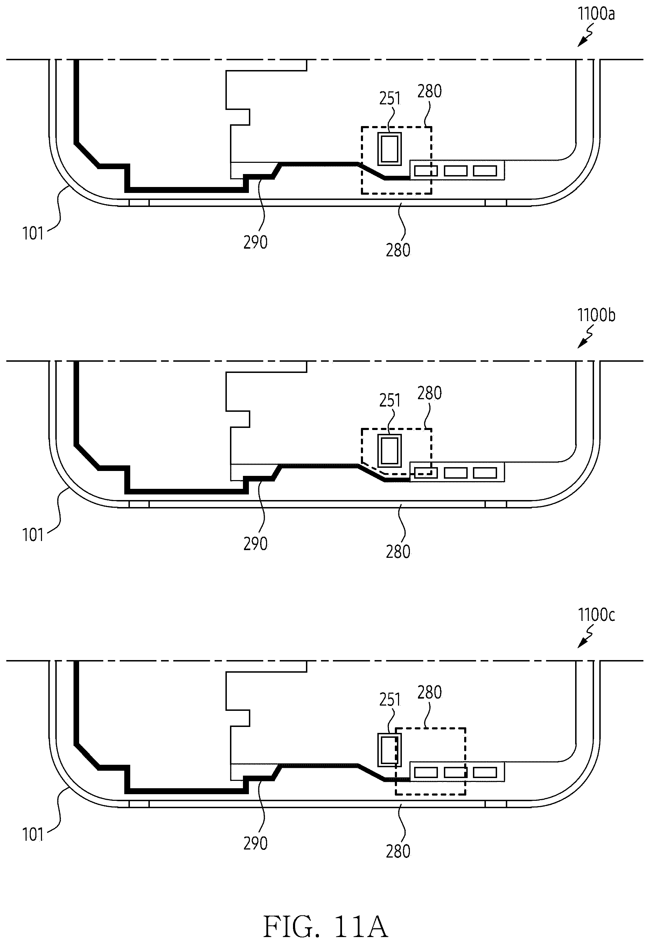

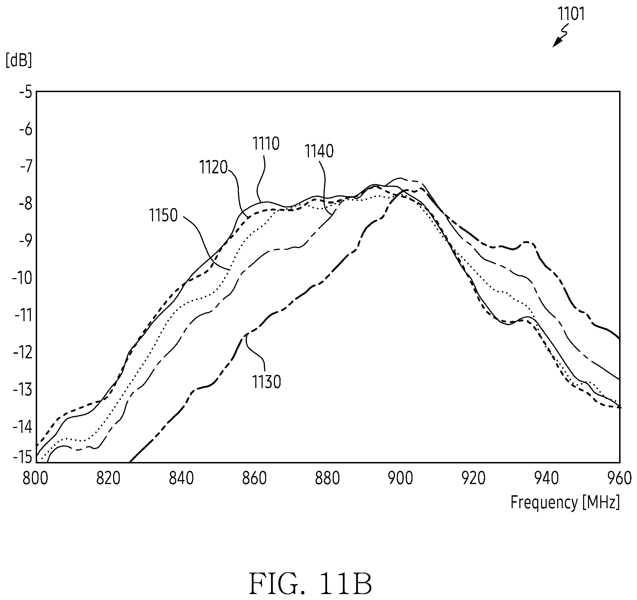

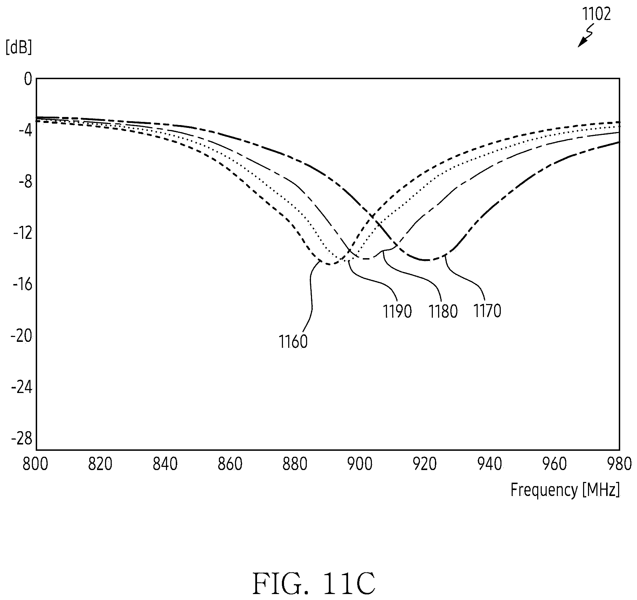

FIG. 11A illustrates a conductive member positioned in various positions. FIG. 11B is a graph indicating a radiation characteristic change of an antenna including at least a portion of a conductive portion according to a position of a conductive member. FIG. 11C is a graph indicating a reflection coefficient of an antenna including at least a portion of a conductive portion according to a position of a conductive member.

Referring to FIG. 11A, the conductive member may be positioned in various positions. For example, referring to 1100a of FIG. 11A, the conductive member 280 may overlap an electronic component 251 (e.g., microphone) and a waterproof structure 290. Referring to 1100b of FIG. 11A, the conductive member 280 may at least partially overlap the electronic component 251 and may be spaced apart from the waterproof structure 290. Referring to 1100c of FIG. 11A, the conductive member 280 may at least partially overlap the electronic component 251. A thickness of the conductive member 280 may be adjusted according to a size of the housing 210 and the design of the electronic device 101. For example, the thickness of the conductive member 280 may be about 0.05 mm to about 0.1 mm, but is not limited thereto.

According to an embodiment, a position of a coupling point (e.g., the coupling point P of FIG. 9B) between the electronic component 251 and the conductive portion 230 formed within the conductive portion 230 may be changed according to a position of the conductive member 280 and/or a thickness of the conductive member 280. As the position of the coupling point P is changed, the resonant frequency of the antenna including at least a portion of the conductive portion 230 may be changed.

The graph 1101 of FIG. 11B illustrates the radiation efficiency of an antenna including a conductive portion (e.g., the conductive portion 230 of FIG. 9A) according to a position or a thickness of the conductive member 280. The first graph 1110 of FIG. 11B illustrates the radiation efficiency of an antenna including at least a portion of the conductive portion 230 when the electronic device 101 does not include the conductive member 280. The second graph 1120 of FIG. 11B illustrates the radiation efficiency of an antenna including at least a portion of the conductive portion 230 when a non-conductive member that does not include a conductive material is positioned at the position illustrated in 1100a of FIG. 11A and the non-conductive member has a thickness of about 0.1 mm. The third graph 1130 of FIG. 11B illustrates the radiation efficiency of an antenna including at least a portion of the conductive portion 230 when the conductive member 280 positioned at the position illustrated in 1100a of FIG. 11A has a thickness of about 0.05 mm. The fourth graph 1140 of FIG. 11B illustrates the radiation efficiency of an antenna including at least a portion of the conductive portion 230 when the conductive member 280 having a thickness of about 0.05 mm is positioned at the position illustrated in 1100b of FIG. 11A. The fifth graph 1150 of FIG. 11B illustrates the radiation efficiency of an antenna including at least a portion of the conductive portion 230 when the conductive member 280 having a thickness of about 0.05 mm is positioned at the position illustrated in 1100c of FIG. 11A.

Referring to FIG. 11B, when the electronic device 101 includes the conductive member 280, a resonant frequency of an antenna including at least a portion of the conductive portion 230 may be high shifted. In a frequency band of about 900 MHz or higher, the first graph 1110 and the second graph 1120 may have a lower gain than the third graph 1130 and the fourth graph 1140. In a frequency band of about 920 MHz or higher, the first graph 1110 and the second graph may have a lower gain than the fifth graph 1150. Comparing the first graph 1110 and the second graph 1120, the first graph 1110 regarding the electronic device 101 not including the conductive member 280 and the second graph 1120 regarding the electronic device 101 including a non-conductive member may be similar to each other. Since a non-conductive member is not able to be coupled to the electronic component 251, it may not move a position of a coupling point (e.g., the coupling point P of FIG. 9A) within the conductive portion 230. Since a resonant frequency of the antenna is not able to be high shifted even when the non-conductive member overlaps the electronic component 251, it may be difficult for the antenna to transmit and/or receive a signal based on a resonant frequency of about 900 MHz. Referring to the third graph 1130, the fourth graph 1140, and the fifth graph 1150, since a position of the coupling point P within the conductive portion 230 is moved close to a feeding portion (e.g., the feeding portion 231f of FIG. 9A) by the conductive member 280, the radiation efficiency of the antenna including at least a portion of the conductive portion 230 in a frequency band of about 900 MHz or higher may be improved. The radiation efficiency of the antenna including at least a portion of the conductive portion 230 may vary according to the position of the conductive member 280.

The graph 1102 of FIG. 11C indicates a reflection coefficient of an antenna including at least a portion of the conductive portion 230 according to the position of the conductive member 280. The sixth graph 1160 of FIG. 11C indicates a reflection coefficient of an antenna including at least a portion of the conductive portion 230 when the electronic device 101 does not include the conductive member 280. The seventh graph 1170 of FIG. 11C indicates a reflection coefficient of an antenna including at least a portion of the conductive portion 230 when the conductive member 280 positioned at the position illustrated in 1100a of FIG. 11A has a thickness of about 0.05 mm. The eighth graph 1180 of FIG. 11C indicates a reflection coefficient of an antenna including at least a portion of the conductive portion 230 when the conductive member 280 having a thickness of about 0.05 mm is positioned at the position illustrated in 1100b of FIG. 11A. The ninth graph 11190 of FIG. 11C indicates a reflection coefficient of an antenna including at least a portion of the conductive portion 230 when the conductive member 280 having a thickness of about 0.05 mm is positioned at the position illustrated in 1100c of FIG. 11A.

Referring to the sixth graph 1160, in the electronic device 101 that does not include the conductive member 280, a resonant frequency of about 880 MHz may be formed for the antenna. In a case of the electronic device 101 that does not include the conductive member 280, as the resonant frequency is low shifted, it may be difficult for the antenna to transmit and/or receive a signal based on a resonant frequency of about 900 MHz. Referring to the seventh graph 1170, the eighth graph 1180, and the ninth graph 1190, as the position of the conductive member 280 is changed, a reflection coefficient of the antenna including at least a portion of the conductive portion 230 may be changed. The third graph 1130 indicates a resonant frequency between about 880 MHz and about 890 MHz, the fourth graph 1140 indicates a resonant frequency of about 890 MHz, and the fifth graph 1150 indicates a resonant frequency of about 910 MHz. Since the coupling point P within the conductive portion 230 is moved close to the feeding portion 231f in the electronic device 101 including the conductive member 280, the resonant frequency of the antenna including at least a portion of the conductive portion 230 may be high shifted. The position of the coupling point P in the conductive portion 230 may be different according to the position of the conductive member 280. According to an embodiment, in order to adjust the resonant frequency of the antenna including at least a portion of the conductive portion 230, the position of the conductive member 280 may be adjusted.

According to an embodiment, an electronic device (e.g., the electronic device 101 of FIG. 2A) may include a processor (e.g., the processor 120 of FIG. 4A), a housing (e.g., the housing 210 of FIG. 2A), a conductive portion (e.g., the conductive portion 230 of FIG. 2A), a printed circuit board (PCB) (e.g., the PCB 240 of FIG. 2A), an electronic component (e.g., the electronic component 251 of FIG. 2A), a switch circuit (e.g., the switch circuit 261 of FIG. 3), and wireless communication circuitry (e.g., the wireless communication circuitry 192 of FIG. 4A). The housing may include a support (e.g., the support 220 of FIG. 2A). The conductive portion may be positioned along at least a portion of a periphery of the housing. The PCB may be electrically connected to the support. The PCB may be configured to provide a first ground (e.g., the first ground G1 of FIG. 3). The PCB may be disposed in the housing. The electronic component may be electrically connected to a ground layer of the PCB through a connecting member (e.g., the connecting member 271 of FIG. 2B). The electronic component may be configured to provide a second ground (e.g., the second ground G2 of FIG. 3) different from the first ground. The switch circuit may be configured to electrically connect the conductive portion to the ground layer of the PCB or the electronic component. The wireless communication circuitry may be configured to communicate with an external electronic device through the conductive portion. The processor may be configured to control the switch circuit, when the wireless communication circuitry transmits or receives a signal on a first frequency band, to electrically connect the conductive portion to the PCB. The processor may be configured to control the switch circuit, when the wireless communication circuitry transmits or receives a signal on a second frequency band higher than the first frequency band, to electrically connect the conductive portion to the electronic component. According to an embodiment of the present disclosure, the electronic device may provide a ground for higher radiation efficiency, based on a frequency band of a signal to be transmitted and/or received through an antenna. The electronic device may include a first ground and a second ground different from each other. The first ground having a relatively large size may be configured to provide a ground for a signal on a first frequency band, which is a relatively low frequency band. The second ground having a relatively small size may be configured to provide a ground for a signal on a second frequency band, which is a relatively high frequency band. According to an embodiment, since a ground for an antenna may be selected as a ground for higher radiation efficiency in accordance with a frequency band, the electronic device may have improved communication performance.

According to an embodiment, the first ground may include the ground layer of the PCB and the support electrically connected to the ground layer. The second ground layer may include at least a portion of a conductive member (e.g., the conductive members 251a and 252a of FIG. 2A) forming an exterior of the electronic component. The electronic component may be electrically connected to the PCB through a first connecting member (e.g., the connecting member 271 of FIG. 3). According to an embodiment of the present disclosure, the first ground may include a support electrically connected to a conductive portion through the PCB. The second ground may include a conductive member of an electronic component electrically connected to a conductive portion through a switch circuit. Since sizes of the first ground and the second ground are different, the electronic device may provide a ground for higher radiation efficiency, based on a frequency band of a signal to be transmitted and/or received through an antenna.

According to an embodiment, the first connecting member may have a capacitance value to block a signal outside the second frequency band, from being provided to the PCB through the first connecting member from the electronic component. According to an embodiment, the electronic component may be electrically connected to the PCB through the first connecting member. According to an embodiment, the first connecting member may distinguish the PCB and the electronic component as a separated region for a radio frequency (RF) signal. The first connecting member may have a designated capacitance value so that the second ground provided by the electronic component may function as a ground different from the first ground. For example, when the electronic component provides the second ground for a signal on a second frequency band, the first connecting member may have a capacitance value to block a signal outside the second frequency band from being provided to the PCB from the electronic component through the first connecting member. Even when the electronic component is electrically connected to the PCB through the first connecting member, the second ground provided by the electronic component may operate as a ground different from the first ground.

According to an embodiment, the PCB may include a first region (e.g., the first region 241 of FIG. 6A) and a second region (e.g., the second region 242 of FIG. 6A). The first region may be electrically connected to the conductive portion. The second region may be different from the first region. The second region may be electrically connected to the electronic component. The first ground may include a ground layer within the first region and the support electrically connected to the first region. The second ground may include at least a portion of a conductive member forming a ground layer within the second region and an exterior of the electronic component. According to an embodiment of the present disclosure, a size of the second ground may be expanded using some region of the PCB. The PCB may include the first region and the second region separated from each other. The ground layer within the second region may operate as the second ground by being connected to the electronic component. When it is insufficient to provide the second ground only by the conductive member of the electronic component, some region of the PCB may operate as the second ground.

According to an embodiment, the electronic device may further include a second connecting member (e.g., the second connecting member 272 of FIG. 6A). The second connecting member may be configured to electrically connect the first region and the second region. The second connecting member may have a capacitance value to block a signal outside the second frequency band from being provided from the second region to the first region through the second connecting member. According to an embodiment of the present disclosure, the first region and the second region may be distinguished as a separated region for the RF signal. The second connecting member may be configured not to pass an RF signal on a designated frequency band so that the first region and the second region may be distinguished. The first region and the second region may be electrically connected through the second connecting member, but may be separated for the RF signal. Since the first region and the second region are separated for the RF signal, the first region and the second region may operate as independent ground, respectively.

According to an embodiment, the electronic device may further include another electronic component (e.g., the second electronic component 252 of FIG. 7A). The other electronic component may be different from the electronic component. The other electronic component may be configured to provide the second ground. The switch circuit may be configured to electrically connect the conductive portion to the PCB or the other electronic component. The processor may be configured to control the switch circuit to electrically connect the conductive portion and the other electronic component when the communication circuitry transmits or receives a signal on the second frequency band. According to an embodiment of the present disclosure, when it is necessary to increase a size of the second ground, the electronic device may use another electronic component (e.g., the second electronic component) connected to the PCB. As the size of the second ground increases, the electronic device may select an optimal ground for a signal on a specific frequency band.

According to an embodiment, the PCB may include a first region and a second region. The first region may be electrically connected to the conductive portion. The second region may be different from the first region. The second region may be electrically connected to the electronic component and the other electronic component. The second ground may include at least a portion of a first conductive member forming an exterior of the electronic component, at least a portion of a second conductive member forming an exterior of the other electronic component, and a ground layer within the second region.

According to an embodiment, the first frequency band may include 600 MHz to 700 MHz. The second frequency band may include 800 MHz to 900 MHz.

According to an embodiment, the conductive portion may include a first conductive portion (e.g., the first conductive portion 231 of FIG. 2A) and a second conductive portion (e.g., the second conductive portion 232 of FIG. 2A). The second conductive portion may be electrically disconnected from the first conductive portion. The electronic device may further include another switch circuit (e.g., the second switch circuit 262 of FIG. 4A). The other switch circuit may be configured to electrically connect the first conductive portion and the second conductive portion. The processor may be configured to control the other switch circuit to electrically disconnect the second conductive portion from the first conductive portion, when the communication circuitry transmits or receives a signal on the first frequency band. The processor may be configured to control the other switch circuit to electrically connect the second conductive portion to the first conductive portion when the communication circuitry transmits or receives a signal on the second frequency band.

According to an embodiment, the housing may include a first periphery (e.g., the first periphery 211 of FIG. 2A), a second periphery (e.g., the second periphery 212 of FIG. 2A) opposite the first periphery, a third periphery (e.g., the third periphery 213 of FIG. 2A), perpendicular to the first periphery, extending from a first end (e.g., the first end 211a of FIG. 2A) of the first periphery to a second end (e.g., the second end 212a of FIG. 2A) of the second periphery, and a fourth periphery (e.g., the fourth periphery 214 of FIG. 2A) opposite the third periphery. The first conductive portion may extend from a first non-conductive portion (e.g., the first non-conductive portion 233 of FIG. 2A) within the first periphery closer to the first end among the first end and the second end to a second non-conductive portion (e.g., the second debt-conductive portion 234 of FIG. 2A) closer to the second end from among the first end and the second. The second conductive portion may extend from the first non-conductive portion to a third non-conductive portion (e.g., the third non-conductive portion 235 of FIG. 2A) in the third periphery through the first end.

According to an embodiment, the housing may include a first periphery, a second periphery opposite the first periphery, a third periphery, perpendicular to the first periphery, extending from a first end of the first periphery to a second end of the second periphery, and a fourth periphery opposite the third periphery. The conductive portion may be positioned along at least a portion of the first periphery. The PCB may be closer to the first periphery among the first periphery and the second periphery.

According to an embodiment, the electronic device may further include a display (e.g., the display 161 of FIG. 2B) and a conductive sheet (e.g., the conductive sheet 162 of FIG. 2B). The display may be positioned over the support. The conductive sheet may be positioned between the display and the support. The conductive sheet may be electrically connected to the support. The first ground may include a ground layer of the PCB, the support electrically connected to the ground layer, and a conductive sheet connected to the ground layer.

According to an embodiment, the electronic component may include at least one of a connection terminal connected to an external electronic device, a speaker, and a microphone.

According to an embodiment, the housing may include a first periphery, a second periphery opposite the first periphery, a third periphery, perpendicular to the first periphery, extending from a first end of the first periphery to a second end of the second periphery, and a fourth periphery opposite the third periphery. The conductive portion may be positioned along at least a portion of the first periphery. The electronic component may be closer to the first periphery among the first periphery and the second periphery.

According to an embodiment, a size of the second ground may be smaller than a size of the first ground. According to an embodiment of the present disclosure, a ground for a specific frequency band may require a different size for higher radiation efficiency. For example, a signal on a relatively low frequency band may have a high radiation efficiency for a relatively large ground, and a signal on a relatively high frequency band may have a high radiation efficiency for a relatively small ground. According to an embodiment, the electronic device may have improved communication performance by providing a ground for a frequency band of a signal.

According to an embodiment, the electronic device may further include a conductive member (e.g., the conductive member 280 of FIG. 8). The conductive member may at least partially overlap the electronic component. The conductive member may be configured to change a coupling position between the conductive portion and the electronic component within the conductive portion, by being coupled to the electronic component. The wireless communication circuitry may be configured to communicate with the external electronic device based on a resonant frequency corresponding to the changed coupling position when transmitting or receiving a signal on the second frequency band.

According to an embodiment, an electronic device may include a processor, a housing, a conductive portion, a printed circuit board (PCB), an electronic component, a switch circuit, wireless communication circuitry, and a conductive member. The housing may include a support. The conductive portion may be positioned along at least a portion of a periphery of the housing. The printed circuit board may be electrically connected to the support and a ground portion of the conductive portion. The printed circuit board may be configured to provide a first ground. The printed circuit board may be disposed in the housing. The electronic component may be electrically connected to a ground layer of the printed circuit board through a connecting member. The electronic component may be configured to provide a second ground different from the first ground. The switch circuit may be configured to electrically connect the conductive portion to a ground layer of the printed circuit board or the electronic component. The wireless communication circuitry may be configured to communicate with an external electronic device through the conductive portion. The conductive member may at least partially overlap the electronic component. The conductive member may change a coupling position between the conductive portion and the electronic component within the conductive portion, by being coupled with the electronic component. The wireless communication circuitry may be configured to communicate with the external electronic device based on a resonant frequency according to the changed coupling position, in a state that the conductive portion and the electronic component are electrically connected through the switch circuit.

According to an embodiment, a resonant frequency of a signal to be transmitted or received through the wireless communication circuitry may be high shifted through the conductive member. According to an embodiment of the present disclosure, the conductive member may be configured to change a coupling position between the conductive portion and the electronic component, in a state that the electronic component is electrically connected to a ground portion within the conductive portion. A position of a coupling point (e.g., the coupling point P of FIG. 9A) formed within the conductive portion by the coupling between the conductive portion and the electronic component may affect a radiation characteristic of the antenna including the conductive portion. For example, as a resonant frequency of a specific frequency band (e.g., 900 MHz) is low shifted in the electronic device, it may be difficult to form the resonant frequency. As the conductive member changes the position of the coupling point, the electronic device may provide the resonant frequency.

According to an embodiment, the electronic device may further include a display. The display may be positioned over the support. The conductive member may be positioned between the electronic component and the display.

According to an embodiment, the housing may further include a cover plate. The cover plate may be positioned under the support. The conductive member may be positioned between the electronic component and the cover plate. According to an embodiment of the present disclosure, a conductive member overlapping the electronic component may be positioned in various positions. The conductive member overlapping the electronic component may be configured to change the position of the coupling point within the conductive portion, by being coupled to the electronic component regardless of its position.

According to an embodiment, a resonant frequency of a signal to be transmitted or received through the wireless communication circuitry may be changed according to the position of the conductive member within the housing. According to an embodiment of the present disclosure, a coupling state between the electronic component and the conductive member may be changed according to the position of the conductive member. Sicne the position of the coupling point within the conductive portion is changed when the position of the conductive member is changed, a radiation characteristic of the antenna including the conductive portion may be changed. According to an embodiment, the radiation characteristic of the antenna may be changed to have higher radiation efficiency by adjusting the position of the conductive member.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a processor;
memory storing instructions;
a housing including a support;
a conductive portion positioned along at least a portion of a periphery of the housing;
a printed circuit board (PCB), electrically connected to the support, providing a first ground;
an electronic component, electrically connected to a ground layer of the PCB through a connecting member, providing a second ground different from the first ground;
a switch circuit configured to electrically connect the conductive portion to the ground layer of the PCB or the electronic component; and
wireless communication circuitry configured to communicate with an external electronic device through the conductive portion,
wherein the instructions, when executed by the processor, cause the electronic device to:
control the switch circuit, when the wireless communication circuitry transmits or receives a signal on a first frequency band, to electrically connect the conductive portion to the PCB, and
control the switch circuit, when the wireless communication circuitry transmits or receives a signal on a second frequency band higher than the first frequency band, to electrically connect the conductive portion to the electronic component.

2. The electronic device of claim 1,
wherein the first ground includes the ground layer of the PCB and the support electrically connected to the ground layer, and
wherein the second ground layer includes at least a portion of a conductive member forming an exterior of the electronic component.

3. The electronic device of claim 2,
wherein the connecting member has a capacitance value to block a signal outside the second frequency band, from being provided to the PCB through the connecting member from the electronic component.

4. The electronic device of any one of claims 1 to 3,
wherein the ground layer of the PCB includes:
a first region electrically connected to the conductive portion, and
a second region, different from the first region, electrically connected to the electronic component,
wherein the first ground includes the first region and the support electrically connected to the first region, and
wherein the second ground includes the second region and at least a portion of a conductive member forming an exterior of the electronic component.

5. The electronic device of claim 4, further comprising another connecting member electrically connecting the first region and the second region,
wherein the other connecting member has a capacitance value to block a signal outside the second frequency band, from being provided to the first region through the other connecting member from the second region.

6. The electronic device of any one of claims 1 to 5, further comprising another electronic component, different from the electronic component, providing the second ground,
wherein the switch circuit is configured to electrically connect the conductive portion to the PCB or the other electronic component,
wherein the instructions, when executed by the processor, cause the electronic device to:
control the switch circuit, when the wireless communication circuitry transmits or receives a signal on the second frequency band, to electrically connect the conductive portion and the other electronic component.

7. The electronic device of claim 6,
wherein the ground layer of the PCB includes:
a first region electrically connected to the ground portion, and
a second region, different from the first region, electrically connected to the electronic component and the other electronic component, and
wherein the second ground includes at least a portion of a first conductive member forming an exterior of the electronic component, at least a portion of a second conductive member forming an exterior of the other electronic component, and a ground layer within the second region.

8. The electronic device of any one of claims 1 to 7,
wherein the first frequency band includes 600MHz to 700MHz, and
wherein the second frequency band includes 800MHz to 900MHz.

9. The electronic device of any one of claims 1 to 8,
wherein the conductive portion includes a first conductive portion and a second conductive portion electrically disconnected from the first conductive portion,
wherein the electronic device includes another switch circuit configured to electrically connect the first conductive portion and the second conductive portion,
wherein the instructions, when executed by the processor, cause the electronic device to:
control the other switch circuit, when the wireless communication circuitry transmits or receives a signal on the first frequency band, to electrically disconnect the second conductive portion from the first conductive portion, and
control the other switch circuit, when the wireless communication circuitry transmits or receives a signal on the second frequency band, to electrically connect the second conductive portion to the first conductive portion.

10. The electronic device of claim 9,
wherein the housing includes:
a first periphery,
a second periphery opposite to the first periphery,
a third periphery, perpendicular to the first periphery, extending from a first end of the first periphery to a second end of the second periphery, and
a fourth periphery opposite to the third periphery,
wherein the first conductive portion extends from a first non-conductive portion in the first periphery closer to the first end from among the first end and the second end to a second non-conductive portion closer to the second end from among the first end and the second, and
wherein the second conductive portion extends from the first non-conductive portion, through the first end, to a third non-conductive portion in the third periphery.

11. The electronic device of any one of claims 1 to 10,
wherein the housing includes:
a first periphery,
a second periphery opposite to the first periphery,
a third periphery, perpendicular to the first periphery, extending from a first end of the first periphery to a second end of the second periphery, and
a fourth periphery opposite to the third periphery,
wherein the conductive portion is positioned along at least a portion of the first periphery, and
wherein the PCB is closer to the first periphery from among the first and the second peripheries.

12. The electronic device of any one of claims 1 to 11, further comprising:
a display positioned over the support; and
a conductive sheet, disposed between the display and the support, electrically connected to the support,
wherein the first ground includes the ground layer of the PCB, the support electrically connected to the ground layer, and the conductive sheet electrically connected to the ground layer.

13. The electronic device of any one of claims 1 to 12,
wherein the electronic component includes at least one of a connection terminal connected to an external electronic device, a speaker, and a microphone.

14. The electronic device of any one of claims 1 to 13,
wherein the housing includes:
a first periphery,
a second periphery opposite to the first periphery,
a third periphery, perpendicular to the first periphery, extending from a first end of the first periphery to a second end of the second periphery, and
a fourth periphery opposite to the third periphery,
wherein the conductive portion is positioned along at least a portion of the first periphery, and
wherein the electronic component is closer to the first periphery from among the first and the second peripheries.

15. The electronic device any one of claims 1 to 14, further comprising a conductive member at least partially overlapping the electronic component,
wherein the conductive member, by being coupled with the electronic component, changes a coupling position between the conductive portion and the electronic component within the conductive portion, and
wherein the wireless communication circuitry is configured to communicate with the external electronic device based on a resonant frequency corresponding to the changed coupling position when transmitting or receiving a signal on the second frequency band.
